# EUROPEAN PATENT SPECIFICATION

(11) **EP 4 489 005 B1**
(45) Date of publication and mention of the grant of the patent: **04.11.2026**
(21) Application number: 24183052.0
(22) Date of filing: 19.06.2024
(51) Int. Cl.: G11C 16/04, G11C 16/34, G11C 29/02, G11C 29/52

(54) **STORAGE DEVICE DETERMINING DETERIORATION WORDLINE, AND METHOD OF OPERATING THE SAME**
SPEICHERVORRICHTUNG MIT BESTIMMUNG DER VERSCHLECHTERUNGSWORTLEITUNG UND VERFAHREN ZUM BETRIEB DAVON
DISPOSITIF DE STOCKAGE DÉTERMINANT UNE LIGNE DE MOTS DE DÉTÉRIORATION ET SON PROCÉDÉ DE FONCTIONNEMENT

(30) Priority: 07.07.2023 KR 20230088309; 29.05.2024 US 202418677544
(43) Date of publication of application: 08.01.2025
(73) Proprietor: Samsung Electronics Co., Ltd., Suwon-si, Gyeonggi-do 16677 (KR)
(72) Inventor: CHO, Minji, 16677 Suwon-si, Gyeonggi-do (KR); KANG, Hee-Woong, 16677 Suwon-si, Gyeonggi-do (KR); KIM, Jin-Young, 16677 Suwon-si, Gyeonggi-do (KR); PARK, Se Hwan, 16677 Suwon-si, Gyeonggi-do (KR); LEE, Ji-Sang, 16677 Suwon-si, Gyeonggi-do (KR); LEE, Heewon, 16677 Suwon-si, Gyeonggi-do (KR); JEON, Su Chang, 16677 Suwon-si, Gyeonggi-do (KR)
(74) Representative: Kuhnen & Wacker Patent- und Rechtsanwaltsbüro PartG mbB

(56) References cited:
- KR-B1- 102 546 274
- US-A1- 2015 043 282
- US-A1- 2021 366 562

## Description

### BACKGROUND

A memory device stores data in response to a write request and outputs data in response to a read request. For example, the memory device is classified as a volatile memory device, which loses data stored therein when a power is turned off, such as a dynamic random access memory (DRAM) device or a static RAM (SRAM) device, or a non-volatile memory device, which retains data stored therein even when a power is turned off, such as a flash memory device, a phase-change RAM (PRAM), a magnetic RAM (MRAM), or a resistive RAM (RRAM).

As memory cells of the non-volatile memory device are programmed based on data bit values, the memory cells may form a threshold voltage distribution corresponding to the data bit values. The threshold voltage distribution may change due to the retention or a physical characteristic of an electronic element over time. The change of the threshold voltage distribution may cause the reduction of reliability. To restrict the reduction of reliability of the non-volatile memory device, it is desired to periodically check the change of the threshold voltage distribution and perform a reliability operation for compensating for the change of the threshold voltage distribution.

US 2015/043282 A1 discloses a method of estimating a deterioration state of a memory device and a related method of wear leveling.

US 2021/366562 A1 discloses a memory system processing a request based on inference and an operating method of the same.

KR 102 546 274 B1 discloses a non-volatile memory device determining read reclaim, a method of operating the same, and a method of operating a storage device having the same.

### SUMMARY

The invention is set out in the appended set of claims. The subject matter of the present disclosure generally relates to a storage device determining a deterioration wordline and a method of operating the storage device.

According to the invention, a method of operating a storage device which includes a storage controller and a non-volatile memory device includes providing, by the storage controller, the non-volatile memory device with a first request indicating a wordline selection operation of a target memory block, obtaining, by the non-volatile memory device, distribution information of a plurality of wordlines of the target memory block based on the first request, determining, by the non-volatile memory device, a deterioration wordline among the plurality of wordlines based on the distribution information, and providing, by the non-volatile memory device, the storage controller with wordline information indicating the deterioration wordline, wherein the distribution information includes a plurality of pieces of wordline distribution information respectively corresponding to the plurality of wordlines, and wherein each of the plurality of pieces of wordline distribution information describes a threshold voltage distribution for threshold voltages of memory cells connected to corresponding word line from among the plurality of wordlines.

According to an aspect, a method of operating a storage device which includes a storage controller and a non-volatile memory device includes providing, by the storage controller, the non-volatile memory device with a first request indicating a wordline selection operation of a target memory block, obtaining, by the non-volatile memory device, distribution information of a plurality of wordlines of the target memory block based on the first request, determining, by the non-volatile memory device, a deterioration wordline among the plurality of wordlines based on the distribution information, determining, by the non-volatile memory device, whether a reclaim condition of the deterioration wordline is satisfied, and providing, by the non-volatile memory device, the storage controller with a determination result response indicating whether the reclaim condition is satisfied.

According to an aspect, a storage device includes a memory cell array that includes a plurality of memory blocks, a storage controller that generates a first request indicating a wordline selection operation of a target memory block among the plurality of memory blocks, and control logic that communicates with the memory cell array and the storage controller. The control logic obtains distribution information through on-chip read operations of a plurality of wordlines of the target memory block based on the first request, determines a deterioration wordline among the plurality of wordlines based on the distribution information, and generates wordline information indicating the deterioration wordline.

### BRIEF DESCRIPTION OF THE FIGURES

FIG. 1 is a block diagram of a storage system according to some implementations of the present disclosure.
FIG. 2 is a block diagram illustrating a storage controller of FIG. 1, according to some implementations of the present disclosure.
FIG. 3 is a block diagram illustrating a non-volatile memory device of FIG. 1, according to some implementations of the present disclosure.
FIG. 4 is a diagram describing a reliability operation of a conventional storage device.
FIG. 5 is a diagram describing a reliability operation of a storage device according to some implementations of the present disclosure.
FIG. 6 is a graph describing operation states of a storage device of FIG. 5, according to some implementations of the present disclosure.
FIG. 7A is a diagram illustrating threshold voltage distributions of single level cells, according to some implementations of the present disclosure.
FIG. 7B is a diagram illustrating threshold voltage distributions of multi-level cells, according to some implementations of the present disclosure.
FIG. 7C is a diagram illustrating threshold voltage distributions of triple level cells, according to some implementations of the present disclosure.
FIG. 7D is a diagram illustrating threshold voltage distributions for quadruple level cells, according to some implementations of the present disclosure.
FIG. 8 is a diagram describing a change of threshold voltage distributions according to some implementations of the present disclosure.
FIG. 9 is a flowchart describing a method of operating a storage device according to some implementations of the present disclosure.
FIG. 10 is a diagram describing a method of operating a non-volatile memory device of FIG. 9, according to some implementations of the present disclosure.
FIG. 11 is a diagram describing a method of operating a storage device according to some implementations of the present disclosure.
FIG. 12 is a flowchart describing a method of operating a storage device according to some implementations of the present disclosure.
FIG. 13 is a flowchart describing a method of operating a non-volatile memory device according to some implementations of the present disclosure.
FIG. 14 is a flowchart describing a method of operating a storage device according to some implementations of the present disclosure.

### DETAILED DESCRIPTION

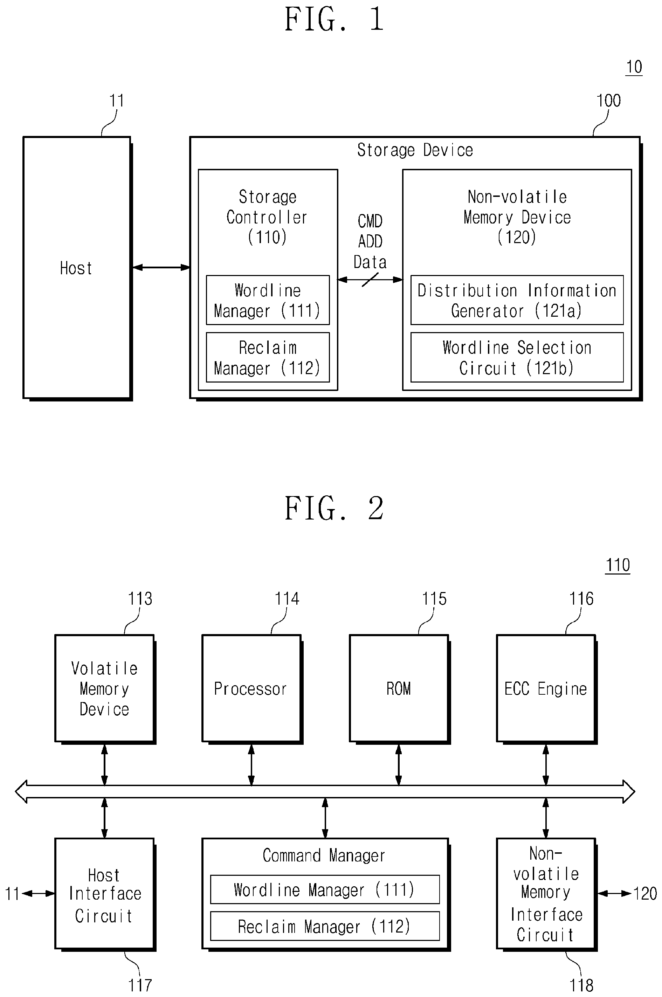

FIG. 1 is a block diagram of a storage system according to some implementations of the present disclosure. Referring to FIG. 1, a storage system 10 includes a host 11 and a storage device 100. In some implementations, the storage system 10 may refer to a computing system, which is configured to process a variety of information, such as a personal computer (PC), a notebook, a laptop, a server, a workstation, a tablet PC, a smartphone, a digital camera, and a black box.

The host 11 may control an overall operation of the storage system 10. For example, the host 11 may store data in the storage device 100 or may read data stored in the storage device 100.

The storage device 100 includes a storage controller 110 and a non-volatile memory device 120. The storage controller 110 may store data in the non-volatile memory device 120 or may read data stored in the non-volatile memory device 120. The non-volatile memory device 120 may operate under control of the storage controller 110. For example, based on a command CMD indicating an operation to be performed and an address ADD indicating a location of data, the storage controller 110 may store data in the non-volatile memory device 120 or may read data stored in the non-volatile memory device 120.

In some implementations, the non-volatile memory device 120 may be a NAND flash memory device, but the present disclosure is not limited thereto. For example, the non-volatile memory device 120 may be one of various storage devices, which retain data stored therein even when a power is turned off, such as a phase-change random access memory (PRAM), a magnetic random access memory (MRAM), a resistive random access memory (RRAM), and a ferroelectric random access memory (FRAM).

The storage controller 110 includes a wordline manager 111 and a reclaim manager 112.

The wordline manager 111 may manage wordlines of a memory block of the non-volatile memory device 120. For example, the wordline manager 111 may provide the non-volatile memory device 120 with a request indicating a wordline selection operation. Based on the request, the non-volatile memory device 120 may determine a deterioration wordline (e.g., a wordline used to provide distribution information that is used to determine a reclaim condition) among a plurality of wordlines in the memory block and may provide the storage controller 110 with wordline information indicating the deterioration wordline. That is, the wordline selection operation may include monitoring the wordlines of the memory block and determining the deterioration wordline.

In some implementations, the wordline selection operation may include monitoring some of all the wordlines of the memory block. The wordlines to be monitored may be designated by the storage controller 110 or may be internally designated by the non-volatile memory device 120.

In some implementations, the wordline manager 111 may periodically provide the non-volatile memory device 120 with the request indicating the wordline selection operation. Alternatively, the wordline manager 111 may provide the non-volatile memory device 120 with the request indicating the wordline selection operation every specific operation (e.g., an operation of reading user data).

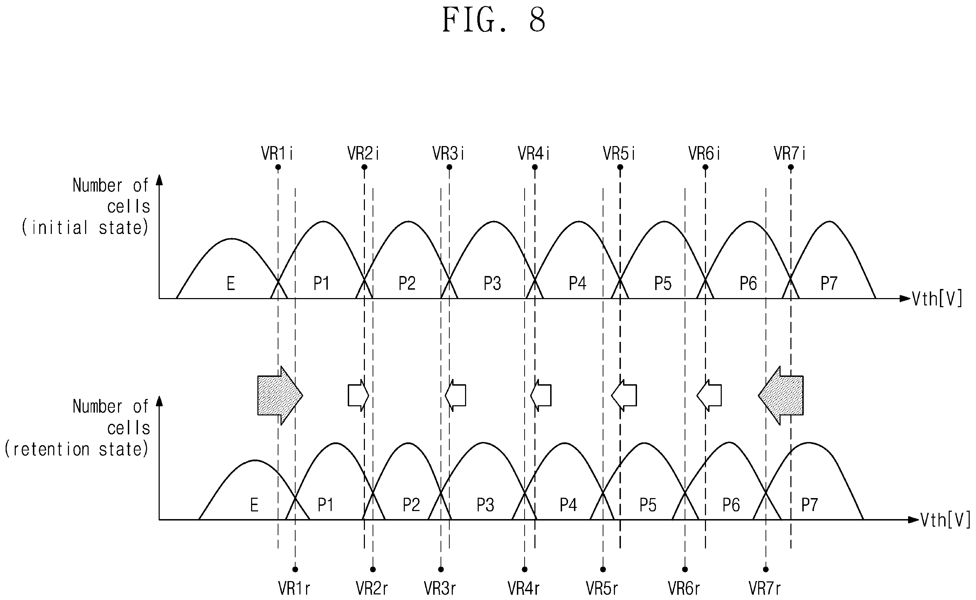

The deterioration wordline may refer to a wordline connected to memory cells whose threshold voltage distribution is seriously changed. The change of the threshold voltage distribution may cause a change in a bit value programmed in a memory cell, thereby reducing the reliability of data stored in the storage device 100. That is, the memory cells of the deterioration wordline may store data having the high probability that the reliability is reduced. The change of the threshold voltage distribution will be described in detail with reference to FIG. 8.

The reclaim manager 112 may provide the non-volatile memory device 120 with a request indicating the read operation of the deterioration wordline, based on the wordline information. The reclaim manager 112 may determine whether a reclaim condition of the memory block including the deterioration wordline is satisfied, based on the data read from the memory cells of the deterioration wordline. A reclaim operation may be performed in units of memory block, but the present disclosure is not limited thereto. For example, the reclaim operation may be performed in units of sub-block smaller than the memory block or may be performed in units of wordline.

The reclaim operation may refer to an operation of copying data of the memory block including the deterioration wordline to any other memory block. The reliability of data of the storage device 100 may be guaranteed by copying data to a new memory block before the threshold voltage distribution is seriously changed. The reclaim operation may be also referred to as a "reliability operation."

For example, the non-volatile memory device 120 may include a first memory block including a deterioration wordline and a second memory block where data are not yet stored. The storage controller 110 may determine that the reclaim condition of the first memory block is satisfied, may read block data of the first memory block (e.g., by using a read voltage whose level is optimized or adjusted), may store the read block data in the second memory block (e.g., after performing an error correction operation of the read block data), and may erase the block data of the first memory block. A series of operations described above may be collectively referred to as a "reclaim operation."

The reclaim condition may provide a criterion for performing the reclaim operation. In detail, when an error count value (e.g., the number of error bits) of the read data of the deterioration wordline exceeds a threshold error count value (e.g., when an uncorrectable error occurs at the deterioration wordline), the reclaim manager 112 may determine that the reclaim condition of the memory block including the deterioration wordline is satisfied (when the reclaim unit is a wordline, the reclaim manager 112 may determine that the deterioration wordline itself satisfies the reclaim condition). Afterwards, the storage controller 110 may perform the reclaim operation by using the read voltage whose level is optimized or adjusted.

The non-volatile memory device 120 includes a distribution information generator 121a and a wordline selection circuit 121b.

The distribution information generator 121a may perform an on-chip read operation. The on-chip read operation may refer to an operation in which the non-volatile memory device 120 or a NAND flash chip internally reads data without the additional communication with the storage controller 110.

For example, the distribution information generator 121a may receive a request indicating the wordline selection operation from the wordline manager 111. Based on the received request, the distribution information generator 121a may perform the on-chip read operation for each of a plurality of wordlines and may generate a plurality of pieces of wordline distribution information respectively corresponding to the plurality of wordlines. The wordline distribution information may indicate a threshold voltage distribution of the corresponding wordline. The plurality of pieces of wordline distribution information may be collectively referred to as "distribution information."

In some implementations, the wordline distribution information may indicate the number of memory cells corresponding to the lowest threshold voltage state or the highest threshold voltage state.

For example, the wordline distribution information may include the number of memory cells, which correspond to the lowest threshold voltage state, from among the memory cells of the corresponding wordline. In other words, the wordline distribution information may include an on-cell count value indicating the number of transistors turned on by the read voltage whose level is the lowest.

As another example, the wordline distribution information may include the number of memory cells, which correspond to the highest threshold voltage state, from among the memory cells of the corresponding wordline. In other words, the wordline distribution information may include an off-cell count value indicating the number of transistors turned off by the read voltage whose level is the highest.

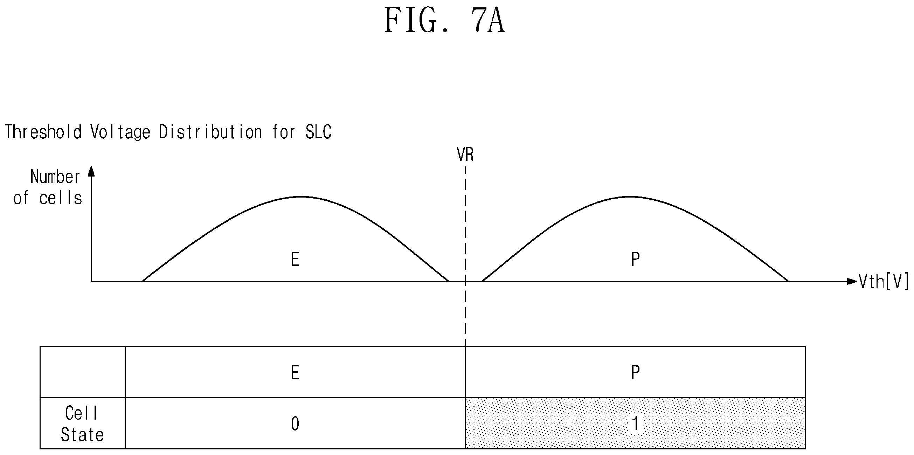

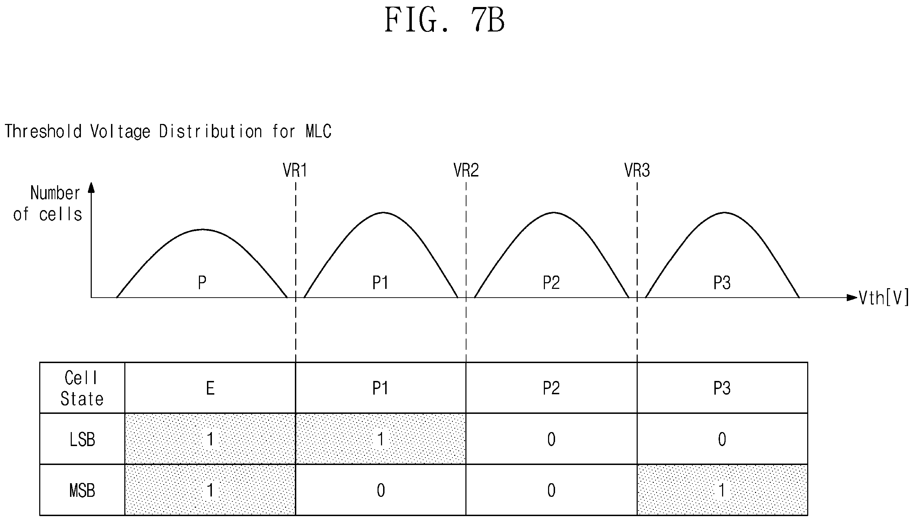

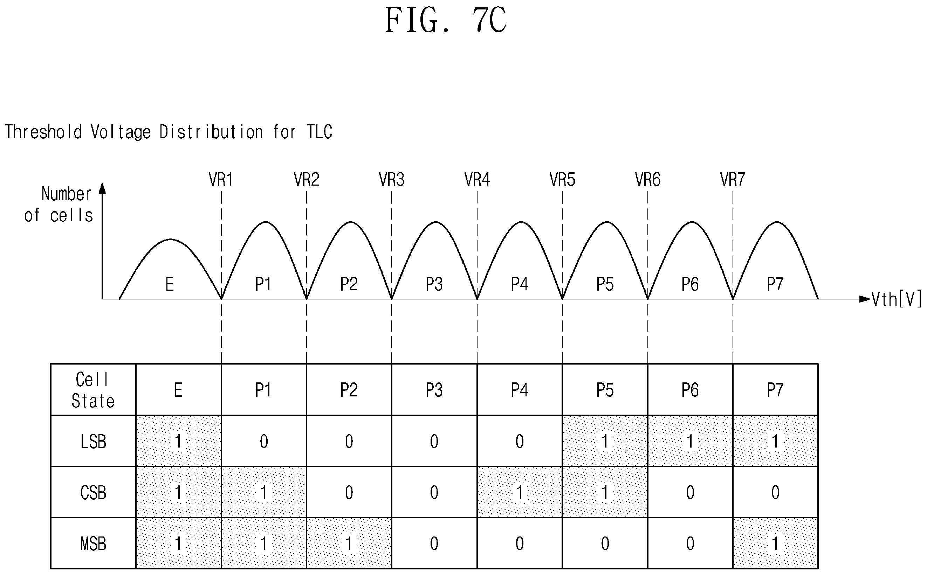

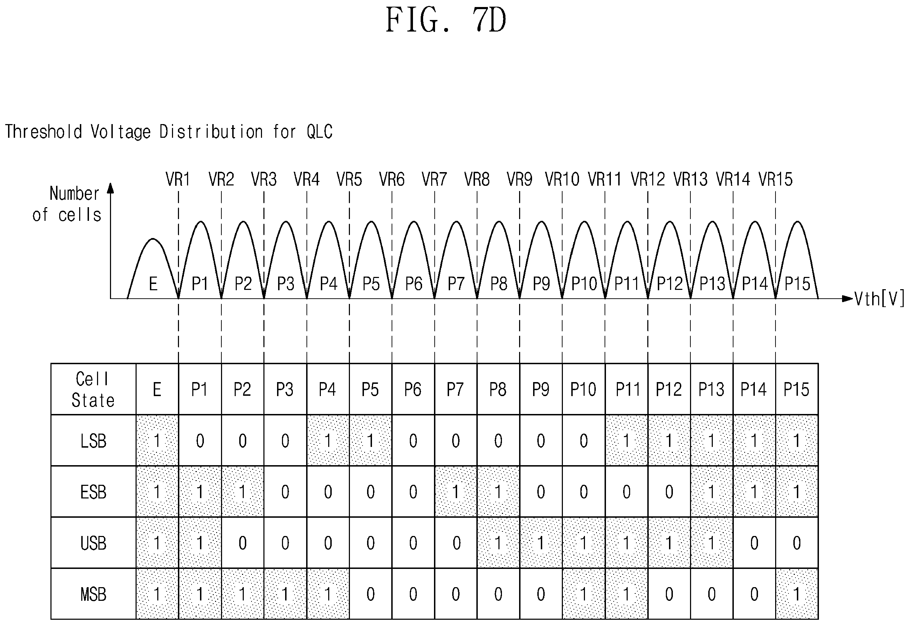

In the above examples, instead of performing a plurality of on-chip read operations by using a plurality of read voltage levels for the purpose of identifying a specific threshold voltage state of memory cells of a wordline, one on-chip read operation may be performed by using one read voltage level for the purpose of identifying only the lowest threshold voltage state or highest threshold voltage state of the memory cells of the wordline, and thus, a speed of the on-chip read operation of the distribution information generator 121a may be improved. That is, the distribution information generator 121a may quickly monitor the deterioration wordline through the on-chip read operation. The threshold voltage state will be described in detail with reference to FIGS. 7A, 7B, 7C, and 7D.

In some implementations, the distribution information generator 121a may use a read voltage level optimized to generate the wordline distribution information. For example, a read voltage level that is used in the on-chip read operation for obtaining the wordline distribution information may be set to be equal to, smaller than, or greater than a default read voltage level appropriate for an initial state.

The wordline selection circuit 121b may determine the deterioration wordline based on the distribution information (e.g., a plurality of pieces of wordline distribution information of a plurality of wordlines). The wordline selection circuit 121b may provide the storage controller 110 with the wordline information indicating the deterioration wordline.

In some implementations, the wordline information may include at least one of an address of the deterioration wordline and wordline distribution information of the deterioration wordline. The storage controller 110 may perform the read operation of the deterioration wordline based on the address of the deterioration wordline as a premise operation for determining the reclaim condition. Alternatively, the storage controller 110 may determine whether the reclaim condition is satisfied, based on the wordline distribution information of the deterioration wordline.

In some implementations, the deterioration wordline may be determined relatively or absolutely. For example, the deterioration wordline may be a wordline, which has the greatest change of a threshold voltage distribution, from among a plurality of wordlines monitored. In this case, the wordline information may indicate one deterioration wordline. As another example, the deterioration wordline may be a wordline, which has a threshold voltage distribution change exceeding a threshold level, from among a plurality of wordlines monitored. In this case, the wordline information may not only indicate one deterioration wordline, but it may also indicate a plurality of wordlines or that there is no deterioration wordline.

FIG. 2 is a block diagram illustrating a storage controller of FIG. 1, according to some implementations of the present disclosure. Referring to FIGS. 1 and 2, the storage controller 110 may communicate with the host 11 and the non-volatile memory device 120.

The storage controller 110 includes the wordline manager 111, the reclaim manager 112, a volatile memory device 113, a processor 114, a read only memory (ROM) 115, an error correcting code (ECC) engine 116, a host interface circuit 117, and a non-volatile memory interface circuit 118. The wordline manager 111 and the reclaim manager 112 may respectively correspond to the wordline manager 111 and the reclaim manager 112 of FIG. 1.

In some implementations, the storage controller 110 includes a command manager. The command manager includes the wordline manager 111 and the reclaim manager 112. The command manager may be implemented with a firmware module. For example, the processor 114 may implement the command manager by loading instructions stored in the non-volatile memory device 120 to the volatile memory device 113 and executing the loaded instructions. However, the present disclosure is not limited thereto. For example, the command manager may be implemented with separate hardware or may be implemented with a combination of hardware and software.

The volatile memory device 113 may be used as a main memory, a buffer memory, or a cache memory of the storage controller 110. The processor 114 may control an overall operation of the storage controller 110. The ROM 115 may be used as a read only memory that stores information used for the operation of the storage controller 110.

The ECC engine 116 may detect and correct an error of data received from the non-volatile memory device 120. The ECC engine 116 may have an error correction capability of a given level. The ECC engine 116 may perform the error correction operation of the read data in units of wordline. For example, when an error level (e.g., the number of flipped bits) of the read data does not exceed the error correction capability of the ECC engine 116, the ECC engine 116 may successfully perform the error correction operation of the read data.

As another example, when the error level of the read data exceeds the error correction capability of the ECC engine 116, the ECC engine 116 may fail in the error correction operation of the read data. In this case, the ECC engine 116 may determine that an uncorrectable error occurs in the read data. When the uncorrectable error occurs, the storage controller 110 may decrease the error level of the read data by again performing the read operation by using the optimized or adjusted read voltage level.

In some implementations, the reclaim manager 112 may determine whether the reclaim condition is satisfied, based on a result of the error correction operation of the ECC engine 116. For example, the reclaim manager 112 may provide the non-volatile memory device 120 with a request indicating the read operation of the deterioration wordline based on the wordline information. The ECC engine 116 may receive the read data of the deterioration wordline from the non-volatile memory device 120. The error count value (e.g., the number of error bits) of the read data may exceed a threshold count value (e.g., the error correction capability of the ECC engine 116). In this case, the ECC engine 116 may fail in the error correction operation. The reclaim manager 112 may detect the fail of the error correction operation of the ECC engine 116 and may determine that the reclaim condition is satisfied.

The storage controller 110 may communicate with the host 11 through the host interface circuit 117. In some implementations, the host interface circuit 117 may be implemented based on at least one of various interfaces such as a serial ATA (SATA) interface, a peripheral component interconnect express (PCIe) interface, a serial attached SCSI (SAS), a non-volatile memory express (NVMe) interface, and a universal flash storage (UFS) interface.

The storage controller 110 may communicate with the non-volatile memory device 120 through the non-volatile memory interface circuit 118. In some implementations, the non-volatile memory interface circuit 118 may be implemented based on the NAND interface.

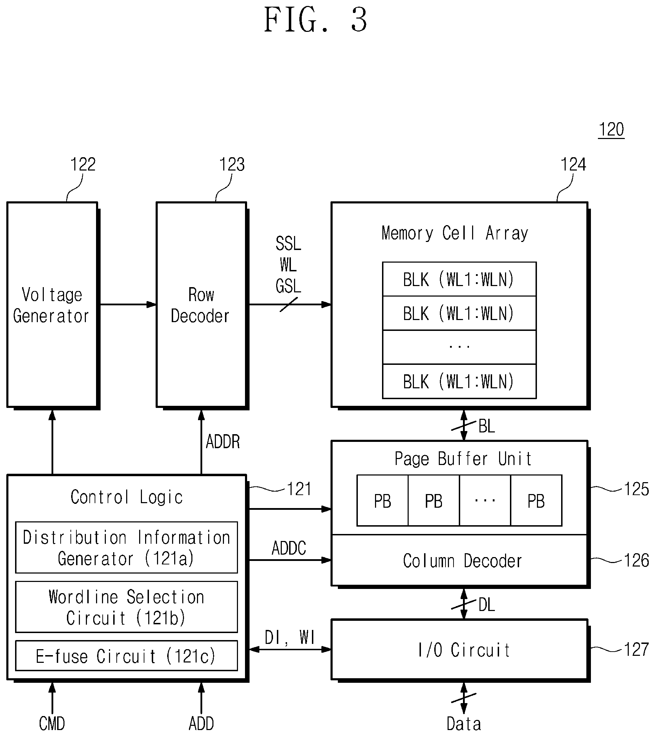

FIG. 3 is a block diagram illustrating a non-volatile memory device of FIG. 1, according to some implementations of the present disclosure. Referring to FIGS. 1 and 3, the non-volatile memory device 120 may communicate with the storage controller 110. For example, the non-volatile memory device 120 may receive the address ADD and the command CMD from the storage controller 110. The non-volatile memory device 120 may communicate data with the storage controller 110.

The non-volatile memory device 120 includes control logic 121, a voltage generator 122, a row decoder 123, a memory cell array 124, a page buffer unit 125, a column decoder 126, and an input/output (I/O) circuit 127.

The control logic 121 may receive the command CMD and the address ADD from the storage controller 110. The command CMD may refer to a signal indicating an operation to be performed by the non-volatile memory device 120, such as a read operation, a write operation, an erase operation, a wordline selection operation, or a reclaim operation. The address ADD may include a row address ADDR and a column address ADDC. The row address ADDR may be used to identify (or select) a wordline. The control logic 121 may control an overall operation of the non-volatile memory device 120 based on the command CMD and the address ADD.

The control logic 121 includes the distribution information generator 121a, the wordline selection circuit 121b, and an E-fuse circuit 121c.

The distribution information generator 121a may monitor a plurality of wordlines WL1 to WLN of a memory block BLK of the memory cell array 124 through the on-chip read operation. Herein, "N" is an arbitrary natural number. For example, when a voltage corresponding to the on-chip read operation is applied to the memory cell array 124, the distribution information generator 121a may generate a plurality of pieces of wordline distribution information respectively corresponding to the plurality of wordlines WL1 to WLN by using the I/O circuit 127. The plurality of pieces of wordline distribution information may be collectively referred to as "distribution information DI." The distribution information generator 121a may obtain the distribution information DI from the I/O circuit 127 and may store the distribution information DI in the E-fuse circuit 121c.

The wordline selection circuit 121b may determine a deterioration wordline among the monitored wordlines WL1 to WLN based on the distribution information DI stored in the E-fuse circuit 121c. The wordline selection circuit 121b may generate wordline information WI indicating the deterioration wordline. The wordline selection circuit 121b may provide the wordline information WI to the storage controller 110 through the I/O circuit 127 in the form of data.

Under control of the control logic 121, the voltage generator 122 may control voltages to be applied to the memory cell array 124 through the row decoder 123.

The row decoder 123 may receive the row address ADDR from the control logic 121. The row decoder 123 may be connected to the memory cell array 124 through string selection lines SSL, wordlines WL, and ground selection lines GSL. The row decoder 123 may decode the row address ADDR and may control voltages to be applied to the string selection lines SSL, the wordlines WL, and the ground selection lines GSL based on a decoding result and voltages received from the voltage generator 122.

The memory cell array 124 includes the plurality of memory blocks BLK. Each of the plurality of memory blocks BLK includes the plurality of wordlines WL1 to WLN. Each of the plurality of wordlines WL1 to WLN may be connected to memory cells. The memory cells may store data.

For example, each of the memory cells may be implemented with various types of memory cells such as a single level cell (SLC) storing one bit, a multi-level cell (MLC) storing two bits, a triple level cell (TLC) storing three bits, a quadruple level cell (QLC) storing four bits. This will be described in detail with reference to FIGS. 7A, 7B, 7C, and 7D.

The page buffer unit 125 includes a plurality of page buffers PB. The page buffer unit 125 may be connected to the memory cell array 124 through bitlines BL. The page buffer unit 125 may read data from the memory cell array 124 by sensing voltages of the bitlines BL under control of the control logic 121. The column decoder 126 may receive the column address ADDC from the control logic 121. The column decoder 126 may decode the column address ADDC and may provide the data read by the page buffer unit 125 to the I/O circuit 127 based on a decoding result. The I/O circuit 127 may provide data received through data lines DL to the storage controller 110.

The I/O circuit 127 may transfer data received from the storage controller 110 to the column decoder 126 through the data lines DL. The column decoder 126 may receive the column address ADDC from the control logic 121. The column decoder 126 may decode the column address ADDC and may provide the data received from the I/O circuit 127 to the page buffer unit 125 based on a decoding result. The page buffer unit 125 may store the data provided from the I/O circuit 127 through the bitlines BL in the memory cell array 124.

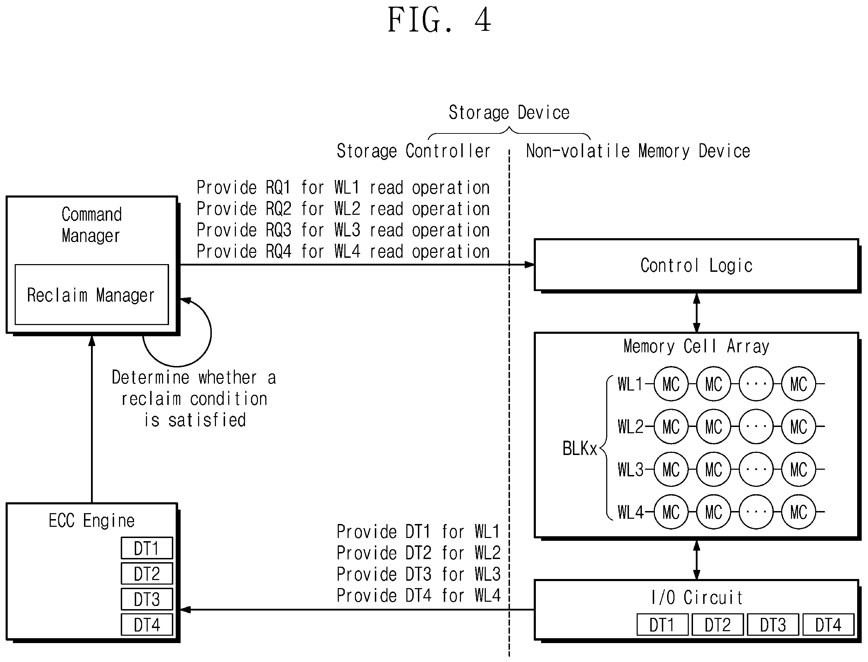

FIG. 4 is a diagram describing a reliability operation of a conventional storage device. The conventional storage device may be provided for better understanding of the present disclosure and is not intended to limit the scope of the invention.

The conventional storage device may include a storage controller and a non-volatile memory device. The storage controller may include a command manager and an ECC engine. The command manager may include a reclaim manager. The non-volatile memory device may include control logic, a memory cell array, and an I/O circuit. The memory cell array may include a target memory block BLKx. The target memory block BLKx may include first to fourth wordlines WL1 to WL4. Each of the first to fourth wordlines WL1 to WL4 may be connected to a plurality of memory cell MC.

For better understanding of the present disclosure, four wordlines WL1 to WL4 are described, but the number of wordlines to be monitored in the target memory block BLKx may be more than or less than 4.

Below, the reliability operation of the conventional storage device will be described.

The command manager may provide the control logic with a first request RQ1 indicating the read operation of the first wordline WL1. The control logic may control the memory cell array based on the first request RQ1 such that first read data DT1 of the first wordline WL1 are output to the I/O circuit. The I/O circuit may provide the first read data DT1 to the ECC engine. The ECC engine may generate an error count value of the first wordline WL1 by performing the error correction operation of the first read data DT1.

As in the above description, the command manager may provide the control logic with second to fourth requests RQ2 to RQ4 respectively corresponding to the second to fourth wordlines WL2 to WL4. The control logic may provide second to fourth read data DT2 to DT4 to the ECC engine through the I/O circuit by performing the read operations in response to the second to fourth requests RQ2 to RQ4. The ECC engine may generate error count values of the second to fourth wordlines WL2 to WL4 by performing the error correction operations of the second to fourth read data DT2 to DT4.

The reclaim manager may obtain the error count values of the first to fourth wordlines WL1 to WL4 from the ECC engine. The reclaim manager may determine whether the reclaim condition of the target memory block BLKx is satisfied, based on the error count values of the first to fourth wordlines WL1 to WL4. When the reclaim unit is smaller in size than the memory block, the reclaim manager may determine whether the reclaim condition of the wordline is satisfied.

For example, when the ECC engine fails in the error correction operation on at least one of the first to fourth wordlines WL1 to WL4 or when an error count value of at least one of the first to fourth read data DT1 to DT4 exceeds the error correction capability of the ECC engine, the reclaim manager may determine that the reclaim condition of the target memory block BLKx is satisfied.

As described above, the conventional storage device may perform the read operations with regard to all the wordlines WL1 to WL4. At least four I/Os (e.g., requests and read data) may be required between the storage controller and the non-volatile memory device. At least four error correction operations may be required in the ECC engine. In this case, the reliability operation of the conventional storage device may be delayed, and power consumption of the conventional storage device may increase.

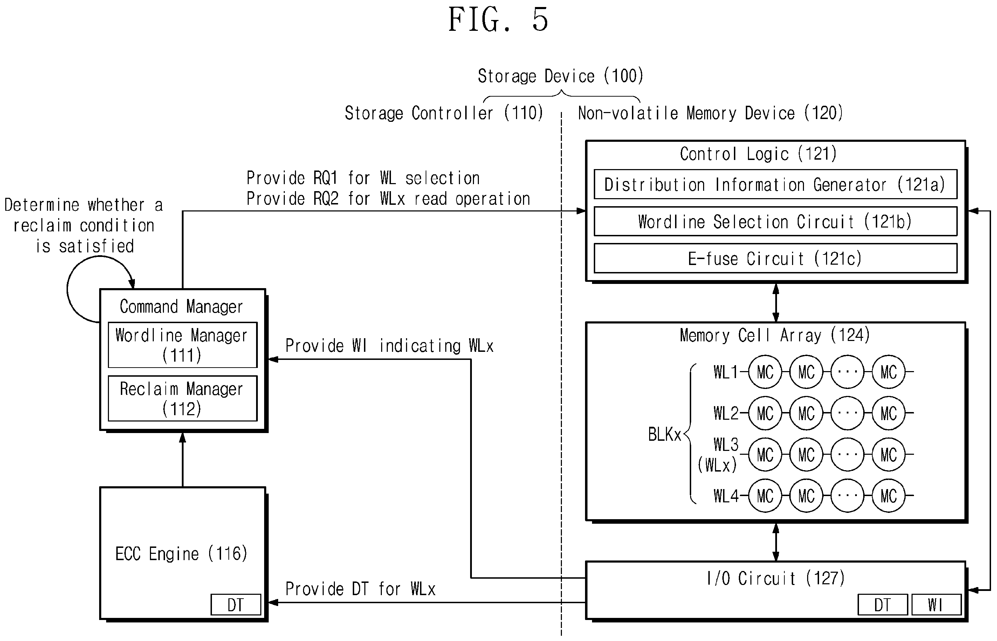

FIG. 5 is a diagram describing a reliability operation of a storage device according to some implementations of the present disclosure. The storage device 100 will be described with reference to FIG. 5. The storage device 100 includes the storage controller 110 and the non-volatile memory device 120. The storage device 100 may correspond to the storage device 100 of FIG. 1. The storage controller 110 may correspond to the storage controller 110 of FIGS. 1 and 2. The non-volatile memory device 120 may correspond to the non-volatile memory device 120 of FIGS. 1 and 3.

The storage controller 110 includes a command manager and the ECC engine 116. The command manager includes the wordline manager 111 and the reclaim manager 112. The non-volatile memory device 120 includes the control logic 121, the memory cell array 124, and the I/O circuit 127. The control logic 121 includes the distribution information generator 121a, the wordline selection circuit 121b, and the E-fuse circuit 121c. The memory cell array 124 includes the target memory block BLKx. The target memory block BLKx includes the first to fourth wordlines WL1 to WL4. Each of the first to fourth wordlines WL1 to WL4 may be connected to the plurality of memory cell MC.

For better understanding of the present disclosure, four wordlines WL1 to WL4 are described, but the number of wordlines to be monitored in the target memory block BLKx may be more than or less than 4.

Below, the reliability operation of the storage device 100 according to some implementations of the present disclosure will be described.

The wordline manager 111 may provide the control logic 121 with the first request RQ1 indicating the wordline selection operation of the target memory block BLKx. The control logic 121 may perform the on-chip read operations with respect to the first to fourth wordlines WL1 to WL4 based on the first request RQ1, respectively. In detail, when the voltage applied to the on-chip read operation is applied to the memory cell array 124, the distribution information generator 121a may generate the distribution information by using the I/O circuit 127. The distribution information may include first to fourth wordline distribution information respectively corresponding to the first to fourth wordlines WL1 to WL4. The distribution information generator 121a may obtain the distribution information from the I/O circuit 127 and may store the distribution information in the E-fuse circuit 121c.

The wordline selection circuit 121b may determine a deterioration wordline WLx among the first to fourth wordlines WL1 to WL4 based on the distribution information stored in the E-fuse circuit 121c. For example, a wordline deteriorated most seriously from among the first to fourth wordlines WL1 to WL4 of the target memory block BLKx may be the third wordline WL3. The wordline selection circuit 121b may determine the third wordline WL3 as the deterioration wordline WLx based on the distribution information stored in the E-fuse circuit 121c. The wordline selection circuit 121b may output the wordline information WI, which indicates that the third wordline WL3 is the deterioration wordline WLx, to the I/O circuit 127. The I/O circuit 127 may provide the wordline information WI to the command manager.

The reclaim manager 112 may provide the control logic 121 with the second request RQ2 indicating the read operation of the deterioration wordline WLx based on the wordline information WI. The control logic 121 may control the memory cell array 124 based on the second request RQ2 and may output the read data DT of the third wordline WL3 being the deterioration wordline WLx to the I/O circuit 127. The I/O circuit 127 may provide the read data DT to the ECC engine 116. The ECC engine 116 may generate an error count value of the third wordline WL3 by performing the error correction operation of the read data DT.

The reclaim manager 112 may obtain the error count value of the third wordline WL3 being the deterioration wordline WLx from the ECC engine 116. Based on the obtained error count value, the reclaim manager 112 may determine whether the reclaim condition of the deterioration wordline WLx itself or the reclaim condition of the target memory block BLKx including the deterioration wordline WLx is satisfied.

For example, when the ECC engine 116 fails in the error correction operation associated with the deterioration wordline WLx or when the error count value of the read data DT of the deterioration wordline WLx exceeds the error correction capability of the ECC engine 116, the reclaim manager 112 may determine that the reclaim condition of the deterioration wordline WLx itself or the reclaim condition of the target memory block BLKx including the deterioration wordline WLx is satisfied.

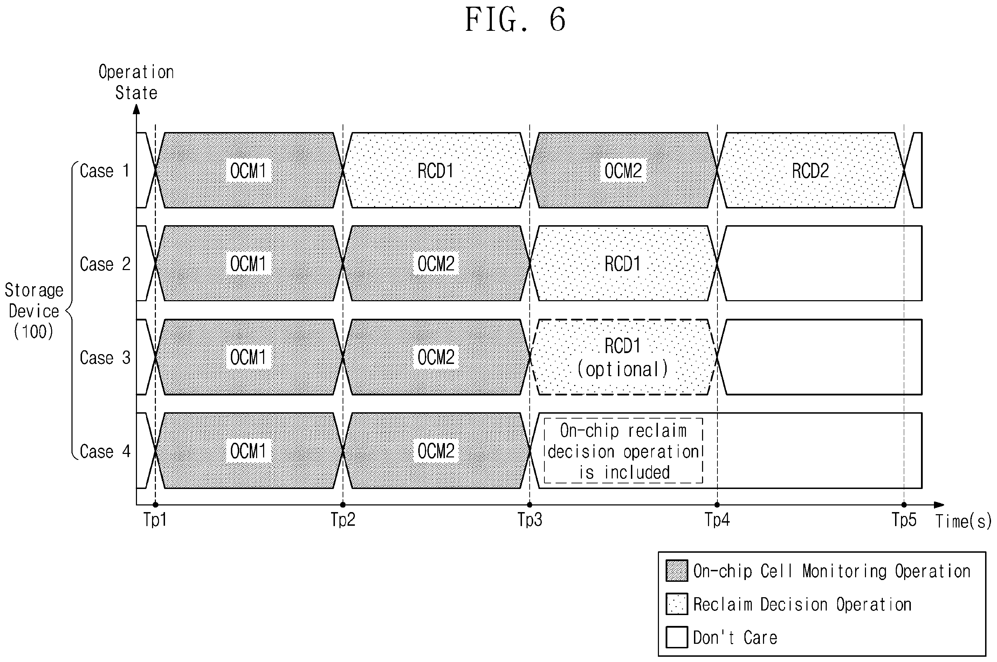

As described above, the storage device 100 may determine the deterioration wordline WLx among the first to fourth wordlines WL1 to WL4 through the on-chip read operations. The I/Os and the error correction operations associated with the remaining wordlines WL1, WL2, and WL4 other than the deterioration wordline WLx may be omitted. That is, the storage device 100 may quickly monitor the deterioration wordline WLx through the on-chip read operation. The delay of the reliability operation may be suppressed, and power consumption in the storage device 100 may decrease. A time advantage of an on-chip operation will be described in detail with reference to FIG. 6.

FIG. 6 is a graph describing operation states of a storage device of FIG. 5, according to some implementations of the present disclosure. How an operation state of the storage device 100 (refer to FIG. 5) changes over time will be described with reference to FIG. 6. In FIG. 6, a horizontal axis represents a time, and a vertical axis represents an operation state of a storage device.

An operation state marked by a dark shade may refer to an on-chip cell monitoring (OCM) operation. The OCM operation may be a portion of the wordline selection operation of FIG. 5. An operation state marked by a light shade may refer to a reclaim decision (RCD) operation. The RCD operation may refer to an operation of determining whether reclaim is required, based on a threshold voltage distribution of a word line selected by the OCM operation. An unshaded operation state may mean a "don't care" state. For example, the unshaded operation state may indicate that the storage device 100 is in an idle state or may indicate that the storage device 100 performs any other operation.

In some implementations, the storage device 100 may operate depending on a first case. The first case may indicate the case where the storage device 100 performs the RCD operation whenever performing the OCM operation. For example, at a first point in time Tp1, the storage device 100 may perform a first OCM operation OCM1 on a first wordline set and may select a first deterioration wordline among wordlines of the first wordline set. At a second point in time Tp2, the storage device 100 may perform a first RCD operation RCD1 based on the read operation of the first deterioration wordline. The first RCD operation RCD1 may be performed to determine whether the reclaim of a memory block including the first deterioration wordline is required.

As in the above description, at a third point in time Tp3, the storage device 100 may perform a second OCM operation OCM2 on a second wordline set and may select a second deterioration wordline among wordlines of the second wordline set. At a fourth point in time Tp4, the storage device 100 may perform a second RCD operation RCD2 based on the read operation of the second deterioration wordline. The second RCD operation RCD2 may be performed to determine whether the reclaim of a memory block including the second deterioration wordline is required. In this case, the first and second wordline sets may be included in the same memory block or may be respectively included in different memory blocks.

In some implementations, the storage device 100 may operate depending on a second case. The second case may indicate the case where the storage device 100 performs the RCD operation after performing a plurality of OCM operations. For example, at the first point in time Tp1, the storage device 100 may perform the first OCM operation OCM1 on the first wordline set. At the second point in time Tp2, the storage device 100 may perform the second OCM operation OCM2 on the second wordline set. In this case, the first and second wordline sets may be included in the same memory block. The storage device 100 may determine a deterioration wordline among wordlines of the first and second wordline sets based on the first and second OCM operations OCM1 and OCM2. The deterioration wordline may be a wordline deteriorated most seriously from among the wordlines of the first and second wordline sets. At the third point in time Tp3, the storage device 100 may perform the first RCD operation RCD 1 based on the read operation of the deterioration wordline.

For better understanding of the present disclosure, the second case including the first and second OCM operations OCM1 and OCM2 is illustrated, but the number of OCM operations corresponding to one RCD operation may be more than 2.

In some implementations, the storage device 100 may operate depending on a third case. The third case may indicate the case where the storage device 100 selectively performs the RCD operation after performing a plurality of OCM operations. For example, at the first point in time Tp1, the storage device 100 may perform the first OCM operation OCM1 on the first wordline set. Based on the absolute deterioration condition, the storage device 100 may determine at least one first deterioration wordlines in the first wordline set or may determine that a deterioration wordline is absent from the first wordline set.

As in the above description, at the second point in time Tp2, the storage device 100 may perform the second OCM operation OCM2 on the second wordline set. Based on the absolute deterioration condition, the storage device 100 may determine at least one second deterioration wordlines in the second wordline set or may determine that a deterioration wordline is absent from the second wordline set. In this case, the first and second wordline sets may be included in the same memory block.

Afterwards, at the third point in time Tp3, the storage device 100 may perform the first RCD operation RCD1 based on the read operation of one of the at least one first deterioration wordlines and the at least one second deterioration wordlines. When a deterioration wordline is absent from the first and second wordline sets, the first RCD operation RCD1 may be omitted.

For better understanding of the present disclosure, the third case including the first and second OCM operations OCM1 and OCM2 is illustrated, but the number of OCM operations corresponding to one RCD operation may be more than 2.

In some implementations, the storage device 100 may operate depending on a fourth case. The fourth case may indicate the case where the storage device 100 performs a reclaim decision operation as an on-chip operation after performing a plurality of OCM operations.

For example, at the first point in time Tp1, the storage device 100 may perform the first OCM operation OCM1 on the first wordline set. At the second point in time Tp2, the storage device 100 may perform the second OCM operation OCM2 on the second wordline set. The storage device 100 may obtain distribution information of a deterioration wordline (e.g., a result of the monitoring or information obtained by an additional read operation of the deterioration wordline) based on the first and second OCM operations OCM1 and OCM2. After the third point in time Tp3, the storage device 100 may perform the on-chip reclaim decision operation based on the distribution information of the deterioration wordline. Because the on-chip reclaim decision operation does not cause an I/O load between a storage controller and a non-volatile memory device, the on-chip reclaim decision operation may be marked as the operation state of "don't care."

FIG. 7A is a diagram illustrating threshold voltage distributions of single level cells, according to some implementations of the present disclosure. A graph of threshold voltage distributions of single level cells SLC each storing one bit and a bit table corresponding to the threshold voltage distributions are illustrated in FIG. 7A.

In the graph of the single level cell SLC, a horizontal axis represents a threshold voltage level, and a vertical axis represents the number of memory cells. The single level cell SLC may have one of an erase state "E" and a programming state "P." The voltage level of the programming state "P" may be higher than the voltage level of the erase state "E." A read voltage level VR may be used to distinguish the erase state "E" from the programming state "P."

The table of the single level cell SLC shows a bit value for each cell state. For example, a bit value corresponding to the erase state "E" may be "0." A bit value corresponding to the programming state "P" may be "1."

FIG. 7B is a diagram illustrating threshold voltage distributions of multi-level cells, according to some implementations of the present disclosure. A graph of threshold voltage distributions of multi-level cells MLC each storing two bits and a bit table corresponding to the threshold voltage distributions are illustrated in FIG. 7B.

In the graph of the multi-level cell MLC, a horizontal axis represents a threshold voltage level, and a vertical axis represents the number of memory cells. The multi-level cell MLC may have one of an erase state "E" and first to third programming states P1 to P3 whose threshold voltage distributions sequentially increase.

In the multi-level cell MLC, a first read voltage level VR1 may be used to distinguish the erase state "E" from the first programming state P1. As in the above description, each of second and third read voltage levels VR2 and VR3 may be used to distinguish each of the second and third programming states P2 and P3 from a previous state (i.e., an immediately previous state having a low threshold voltage distribution).

The table of the multi-level cell MLC shows a least significant bit LSB and a most significant bit MSB for each cell state. The least significant bit LSB may correspond to a first logical page of the multi-level cell MLC. The most significant bit MSB may correspond to a second logical page of the multi-level cell MLC.

In some implementations, the first to third read voltage levels VR1 to VR3 of the multi-level cell MLC may be used to perform the read operation on one of the first and second logical pages. For example, in the multi-level cell MLC, the read operation of the first logical page may be performed based on the second read voltage level VR2. The read operation of the second logical page may be performed based on the first and third read voltage levels VR1 and VR3.

FIG. 7C is a diagram illustrating threshold voltage distributions of triple level cells, according to some implementations of the present disclosure. A graph of threshold voltage distributions of triple level cells TLC each storing three bits and a bit table corresponding to the threshold voltage distributions are illustrated in FIG. 7C.

In the graph of the triple level cell TLC, a horizontal axis represents a threshold voltage level, and a vertical axis represents the number of memory cells. The triple level cell TLC may have one of an erase state "E" and first to seventh programming states P1 to P7 whose threshold voltage distributions sequentially increase.

In the triple level cell TLC, a first read voltage level VR1 may be used to distinguish the erase state "E" from the first programming state P1. As in the above description, each of second to seventh read voltage levels VR2 to VR7 may be used to distinguish each of the second to seventh programming states P2 to P7 from a previous state (i.e., an immediately previous state having a low threshold voltage distribution).

The table of the triple level cell TLC shows a least significant bit LSB, a center significant bit CSB, and a most significant bit MSB for each cell state. The least significant bit LSB may correspond to a first logical page of the triple level cell TLC. The center significant bit CSB may correspond to a second logical page of the triple level cell TLC. The most significant bit MSB may correspond to a third logical page of the triple level cell TLC.

In some implementations, the first to seventh read voltage levels VR1 to VR7 of the triple level cell TLC may be used to perform the read operation on one of the first to third logical pages. For example, in the triple level cell TLC, the read operation of the first logical page may be performed based on the first and fifth read voltage levels VR1 and VR5. The read operation of the second logical page may be performed based on the second, fourth, and sixth read voltage levels VR2, VR4, and VR6. The read operation of the third logical page may be performed based on the third and seventh read voltage levels VR3 and VR7.

FIG. 7D is a diagram illustrating threshold voltage distributions for quadruple level cells, according to some implementations of the present disclosure. A graph of threshold voltage distributions of quadruple level cells QLC each storing four bits and a bit table corresponding to the threshold voltage distributions are illustrated in FIG. 7D.

In the graph of the quadruple level cell QLC, a horizontal axis represents a threshold voltage level, and a vertical axis represents the number of memory cells. The quadruple level cell QLC may have one of an erase state "E" and first to fifteenth programming states P1 to P15 whose threshold voltage distributions sequentially increase.

In the quadruple level cell QLC, a first read voltage level VR1 may be used to distinguish the erase state "E" from the first programming state P1. As in the above description, each of second to fifteenth read voltage levels VR2 to VR15 may be used to distinguish each of the second to fifteenth programming states P2 to P15 from a previous state (i.e., an immediately previous state having a low threshold voltage distribution).

The table of the quadruple level cell QLC shows a least significant bit LSB, a first center significant bit ESB, a second center significant bit USB, and a most significant bit MSB for each cell state. The least significant bit LSB may correspond to a first logical page of the quadruple level cell QLC. The first center significant bit ESB may correspond to a second logical page of the quadruple level cell QLC. The second center significant bit USB may correspond to a third logical page of the quadruple level cell QLC. The most significant bit MSB may correspond to a fourth logical page of the quadruple level cell QLC.

In some implementations, the first to fifteenth read voltage levels VR1 to VR15 of the quadruple level cell QLC may be used to perform the read operation on one of the first to fourth logical pages. For example, in the quadruple level cell QLC, the read operation of the first logical page may be performed based on the first, fourth, sixth, and eleventh read voltage levels VR1, VR4, VR6, and VR11. The read operation of the second logical page may be performed based on the third, seventh, ninth, and thirteenth read voltage levels VR3, VR7, VR9, and VR13. The read operation to the third logical page may be performed based on the second, eighth, and fourteenth read voltage levels VR2, VR8, and VR14. The read operation to the fourth logical page may be performed based on the fifth, tenth, twelfth, and fifteenth read voltage levels VR5, VR10, VR12, and VR15.

As described above, cell states and read voltage levels of the single level cell SLC, the multi-level cell MLC, the triple level cell TLC, and the quadruple level cell QLC are described with reference to FIGS. 7A to 7D. In the case of the single level cell SLC, a threshold voltage state may be identified by one read voltage level, and thus, the read operation may be quickly performed. In the case of the remaining cells MLC, TLC, and QLC, because some threshold voltage states are identified by a plurality of read voltage levels, the read operation may be slowly performed; however, because two or more bits are stored per memory cell, the storage capacity may increase.

FIG. 8 is a diagram describing a change of threshold voltage distributions, according to some implementations of the present disclosure. Threshold voltage distributions of an initial state and threshold voltage distributions of a retention state will be described with reference to FIG. 8. The initial state may refer to a state at a point in time (i.e., an initial point in time) when memory cells are programmed to form threshold voltage distributions. The retention state may refer to a state at a point in time when a time passes from the initial state or a state at a point in time when the reclaim operation is required.

In the graph of the initial state, a horizontal axis represents a threshold voltage level, and a vertical axis represents the number of memory cells. A threshold voltage level of each memory cell may correspond to one of the erase state "E" and the first to seventh programming states P1 to P7. A first initial read voltage level VR1i may be a voltage level of a valley optimized to distinguish memory cells of the erase state "E" from memory cells of the first programming state P1.

The optimized valley may indicate a voltage level at which the number of memory cells each having an error bit (i.e., the number of memory cells each determined as a bit value opposite to a programmed bit value) is minimized. For example, in the case of distinguishing the erase state "E" and the first programming state P1 in the initial state, the voltage level of the optimized valley may indicate a voltage level, at which the number of memory cells is minimized, between a voltage level at which the number of memory cells each having the erase state "E" is maximized and a voltage level at which the number of memory cells each having the first programming state P1 is maximized.

As in the above description, in the initial state, each of second to seventh initial read voltage levels VR2i to VR7i may indicate a voltage level of a valley optimized to distinguish each of the second to seventh programming states P2 to P7 from a previous state (i.e., an immediately previous state having a low threshold voltage distribution).

In the graph of the retention state, a horizontal axis represents a threshold voltage level, and a vertical axis represents the number of memory cells. A threshold voltage level of each memory cell may correspond to one of the erase state "E" and the first to seventh programming states P1 to P7. A first retention read voltage level VR1r may be a voltage level of a valley optimized to distinguish memory cells of the erase state "E" from memory cells of the first programming state P1.

As in the above description, in the retention state, each of second to seventh retention read voltage levels VR2r to VR7r may indicate a voltage level of a valley optimized to distinguish each of the second to seventh programming states P2 to P7 from a previous state (i.e., an immediately previous state having a low threshold voltage distribution).

Referring to the graph of the initial state and the graph of the retention state together, each of the first to seventh initial read voltage levels VR1i to VR7i may be different from each of the first to seventh retention read voltage levels VR1r to VR7r.

In some implementations, the highest threshold voltage state and the lowest threshold voltage state may be prone to deterioration over time. The highest threshold voltage state and the lowest threshold voltage state may be utilized as key factors of the reclaim condition.

For example, as the threshold voltage level becomes higher, the decrement of the voltage level in the retention state may become greater. In detail, a difference between the seventh retention read voltage level VR7r and the seventh initial read voltage level VR7i may be greater than a difference between the third retention read voltage level VR3r and the third initial read voltage level VR3i. In detail, in the case of the highest programming state (i.e., P7 of the triple level cell TLC), because a threshold voltage level is shifted left due to the charge loss, over time, the highest programming state may be shifted downwards to be greater than any other programming state.

As another example, a voltage level corresponding to a low threshold voltage state may increase over time. In detail, to increase a time during which the reliability of an erase state and programming states of memory cells is guaranteed, memory cells may be programmed to have a threshold voltage level higher than the threshold voltage level of the erase state at a semiconductor process step. At an actual use step, a memory cell programmed to the erase state may have a property of returning to the threshold voltage level programmed at the semiconductor process step over time. As such, the first retention read voltage level VR1r may be higher than the first initial read voltage level VR1i. Alternatively, because the threshold voltage level of the erase state "E" is shifted right due to the read disturb caused by a plurality of read operations, over time, the lowest state (i.e., the erase state) may be shifted upwards to be greater than any other programming state.

As described above, the change of the threshold voltage distribution in the retention state may dominantly occur in the lowest threshold voltage state and the highest threshold voltage state. Whether the reclaim operation is required may be efficiently determined by monitoring the lowest threshold voltage state or the highest threshold voltage state instead of monitoring the deterioration of all the threshold voltage states.

For example, when the number of memory cells determined as the erase state "E" (i.e., an on-cell count value) is smaller than a first threshold value or when the number of memory cells determined as the seventh programming state P7 (i.e., an off-cell count value) is smaller than a second threshold value, the reclaim operation may be required. For better understanding of the present disclosure, the triple level cell TLC is described as an example, but the present disclosure is not limited thereto. In the case of the quadruple level cell QLC, when the number of memory cells determined as the erase state "E" (i.e., an on-cell count value) is smaller than the first threshold value or when the number of memory cells determined as the fifteenth programming state P15 (i.e., an off-cell count value) is smaller than the second threshold value, the reclaim operation may be required.

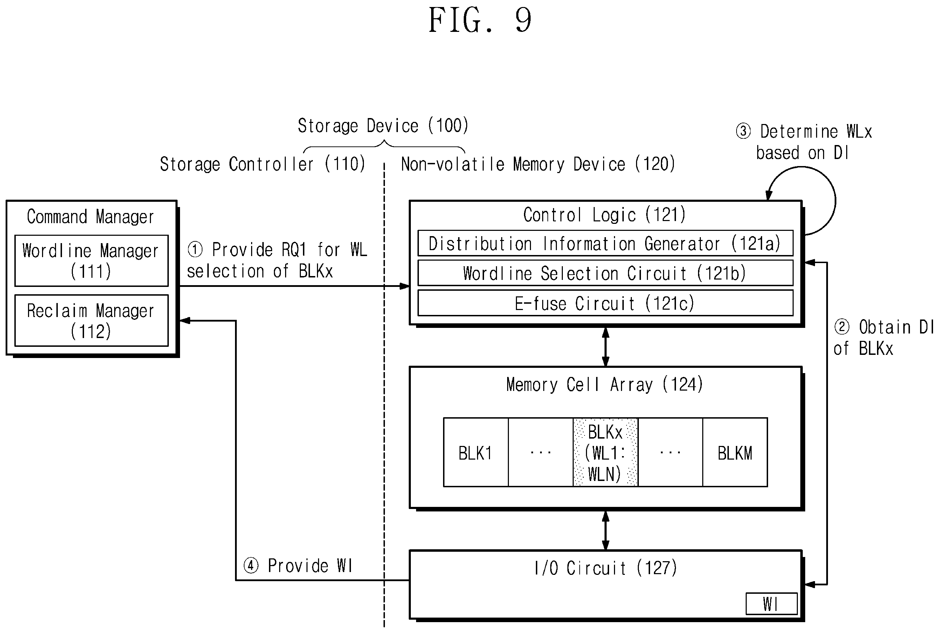

FIG. 9 is a flowchart describing a method of operating a storage device according to some implementations of the present disclosure. Referring to FIG. 9, the storage device 100 includes the storage controller 110 and the non-volatile memory device 120. The storage controller 110 includes a command manager. The command manager includes the wordline manager 111 and the reclaim manager 112. The non-volatile memory device 120 includes the control logic 121, the memory cell array 124, and the I/O circuit 127. The control logic 121 includes the distribution information generator 121a, the wordline selection circuit 121b, and the E-fuse circuit 121c. The memory cell array 124 includes a plurality of memory blocks BLK1 to BLKM. Herein, "M" is an arbitrary natural number.

Below, the wordline selection operation of the storage device 100 will be described.

In a first operation ①, the wordline manager 111 may provide the control logic 121 with the first request RQ1 indicating the wordline selection operation of the target memory block BLKx among the plurality of memory blocks BLK1 to BLKM. The first request RQ1 may include addresses of the first to N-th wordlines WL1 to WLN of the target memory block BLKx or may include addresses of wordlines selected from the first to N-th wordlines WL1 to WLN.

In a second operation ②, based on the first request RQ1, the control logic 121 may perform the on-chip read operation in units of wordline and may obtain the distribution information DI of the target memory block BLKx. For example, when a voltage corresponding to the on-chip read operation is applied to the memory cell array 124, the distribution information generator 121a may generate first to N-th wordline distribution information respectively corresponding to the first to N-th wordlines WL1 to WLN by using the I/O circuit 127. The first to N-th wordline distribution information may be collectively referred to as "distribution information DI." The distribution information generator 121a may obtain the distribution information DI from the I/O circuit 127. The distribution information generator 121a may store the distribution information DI in the E-fuse circuit 121c.

In some implementations, the distribution information generator 121a may perform the on-chip read operation in the single level cell (SLC) manner. For example, memory cells connected to the first to N-th wordlines WL1 to WLN may be implemented with the triple level cell TLC. Instead of performing the on-chip read operation in units of logical page by using a plurality of read voltage levels, the distribution information generator 121a may read memory cells corresponding to the lowest threshold voltage state (e.g., the erase state "E") by using only the first read voltage level VR1 or may read memory cells corresponding to the highest threshold voltage state (e.g., the seventh programming state P7) by using only the seventh read voltage level VR7.

In some implementations, each of the plurality of pieces of wordline distribution information included in the distribution information DI may include at least one of an on-cell count value of the corresponding wordline, an off-cell count value of the corresponding wordline, valley search information of the corresponding wordline, and a cell count value between two adjacent read voltages.

In detail, the on-cell count value may indicate the number of memory cells determined to have the lowest threshold voltage state from among memory cells connected to the corresponding wordline. As the on-cell count value becomes smaller, the degree of deterioration of the corresponding wordline may become more serious.

The off-cell count value may indicate the number of memory cells determined to have the highest threshold voltage state from among the memory cells connected to the corresponding wordline. As the off-cell count value becomes smaller, the degree of deterioration of the corresponding wordline may become more serious.

With regard to the corresponding wordline, the valley search information may refer to a difference value of a voltage level of a valley in the initial state and a voltage level of an optimized valley when the on-chip read operation is performed. As the difference value corresponding to the valley search information becomes greater, the degree of deterioration of the corresponding wordline may become more serious.

The cell count value between two adjacent read voltages may indicate the number of memory cells corresponding to a specific threshold voltage state. The two adjacent read voltages may be two read voltages determined in advance.

The cell count value of two adjacent read voltages may indicate the number of memory cells each having a threshold voltage state between two adjacent read voltage levels associated with the single level cell SLC, the multi-level cell MLC, the triple level cell TLC, or the quadruple level cell QLC. For example, when the specific threshold voltage state is the first programming state P1, the cell count value may indicate the number of memory cells each having a threshold voltage level between the first read voltage level VR1 and the second read voltage level VR2. The degree of deterioration of the corresponding wordline may be determined depending on the decrement or increment of the cell count value. A way to determine the degree of deterioration may be variously determined depending on a type of a memory cell (e.g., an TLC or a QLC), a kind of a threshold voltage state, a device characteristic, etc.

In detail, the deterioration wordline WLx may be a wordline, at which the cell count value between two adjacent read voltages is the smallest, from among the first to N-th wordlines WL1 to WLN. Alternatively, the deterioration wordline WLx may be a wordline, at which the cell count value between two adjacent read voltages is the greatest, from among the first to N-th wordlines WL1 to WLN.

As another example, the deterioration wordline WLx may be a wordline, at which the cell count value of two adjacent read voltages is greater than a third threshold value, from among the first to N-th wordlines WL1 to WLN (this may mean that a plurality of deterioration wordlines exist). Alternatively, the deterioration wordline WLx may be a wordline, at which the cell count value of two adjacent read voltages is smaller than a fourth threshold value, from among the first to N-th wordlines WL1 to WLN (this may mean that a plurality of deterioration wordlines exist).

In a third operation ③, the wordline selection circuit 121b may determine the deterioration wordline WLx among the first to N-th wordlines WL1 to WLN based on the distribution information DI. The deterioration wordline WLx may be determined relatively or absolutely. The wordline selection circuit 121b may generate the wordline information WI indicating the deterioration wordline WLx.

In some implementations, the wordline information WI may include at least one of an address of the deterioration wordline WLx and the wordline distribution information of the deterioration wordline WLx.

In some implementations, the wordline selection circuit 121b may determine a wordline, at which the number of memory cells of the lowest threshold voltage state is the smallest, from among the wordlines WL1 to WLN as the deterioration wordline WLx. For example, the lowest threshold voltage state may be the erase state "E" of the triple level cell TLC or the erase state "E" of the quadruple level cell QLC. The distribution information DI may include the on-cell count value for each of the wordlines WL1 to WLN. The on-cell count value may indicate the number of memory cells turned on in the lowest threshold voltage state. The wordline selection circuit 121b may determine a wordline having the smallest on-cell count value from among the wordlines WL1 to WLN as the deterioration wordline WLx, based on the distribution information DI.

In some implementations, the wordline selection circuit 121b may determine, from among the wordlines WL1 to WLN as the deterioration wordline WLx, a wordline whose on-cell count value is smaller than the first threshold value. The first threshold value may provide a criterion of the decision of the deterioration wordline WLx, which is made based on the on-cell count value. When the number of wordlines having the on-cell count value smaller than the first threshold value is 2 or more, the wordline information WI may indicate a plurality of deterioration wordlines. When there is no wordline having the on-cell count value smaller than the first threshold value, the wordline information WI may indicate that there is no deterioration wordline.

In some implementations, the wordline selection circuit 121b may determine, from among the wordlines WL1 to WLN as the deterioration wordline WLx, a wordline at which the number of memory cells of the highest threshold voltage state is the smallest. For example, the highest threshold voltage state may be the seventh programming state P7 of the triple level cell TLC or the fifteenth programming state P15 of the quadruple level cell QLC. The distribution information DI may include the off-cell count value for each of the wordlines WL1 to WLN. The off-cell count value may indicate the number of memory cells turned off in the highest threshold voltage state. The wordline selection circuit 121b may determine a wordline having the smallest off-cell count value from among the wordlines WL1 to WLN as the deterioration wordline WLx, based on the distribution information DI.

In some implementations, the wordline selection circuit 121b may determine, from among the wordlines WL1 to WLN as the deterioration wordline WLx, a wordline whose off-cell count value is smaller than the second threshold value. The second threshold value may provide a criterion of the decision of the deterioration wordline WLx, which is made based on the off-cell count value. When the number of wordlines having the off-cell count value smaller than the second threshold value is 2 or more, the wordline information WI may indicate a plurality of deterioration wordlines. When there is no wordline having the off-cell count value smaller than the second threshold value, the wordline information WI may indicate that there is no deterioration wordline.

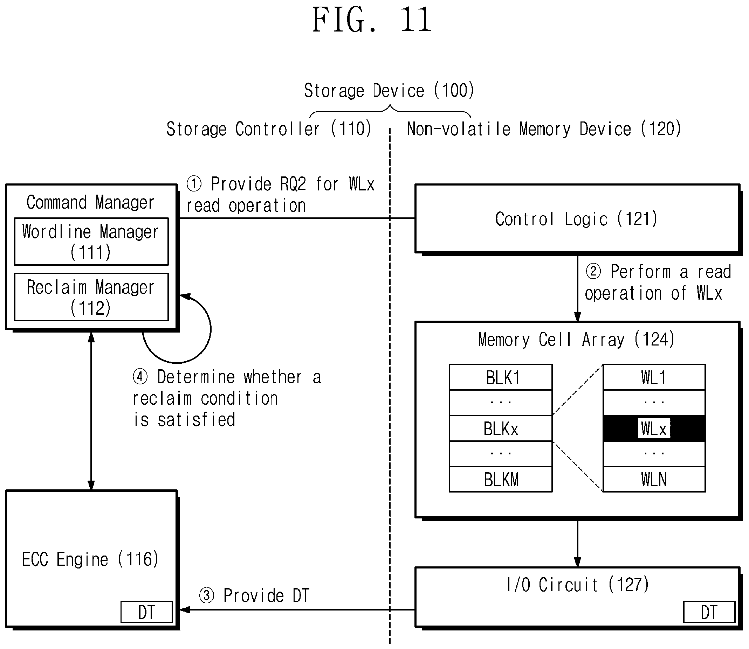

In a fourth operation ④, the wordline selection circuit 121b may provide the wordline information WI to the command manager through the I/O circuit 127. Afterwards, the command manager may perform the read operation based on the wordline information WI. This will be described in detail with reference to FIG. 11.

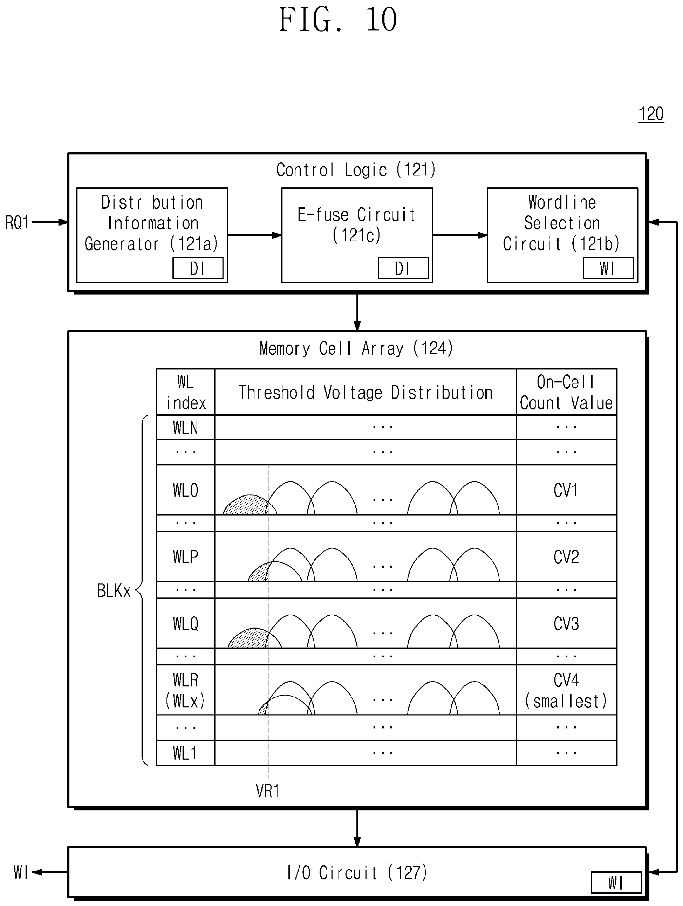

FIG. 10 is a diagram describing a method of operating a non-volatile memory device of FIG. 9, according to some implementations of the present disclosure. Referring to FIG. 10, the non-volatile memory device 120 includes the control logic 121, the memory cell array 124, and the I/O circuit 127. The control logic 121 includes the distribution information generator 121a, the wordline selection circuit 121b, and the E-fuse circuit 121c. The memory cell array 124 includes the target memory block BLKx. The target memory block BLKx includes the first to N-th wordlines WL1 to WLN.

The control logic 121 may receive the first request RQ1 indicating the wordline selection operation of the target memory block BLKx. Wordlines to be monitored for the wordline selection operation may be designated through the first request RQ1 or may be internally designated by the non-volatile memory device 120. The wordlines to be monitored may be some of all the wordlines of the target memory block BLKx. For example, the target memory block BLKx includes the first to N-th wordlines WL1 to WLN. Some wordlines WLO, WLP, WLQ, and WLR among the first to N-th wordlines WL1 to WLN may be prone to deterioration. The non-volatile memory device 120 may monitor not all the wordlines WL1 to WLN of the target memory block BLKx but some wordlines WLO, WLP, WLQ, and WLR of the target memory block BLKx and may determine the deterioration wordline WLx.

For better understanding of the present disclosure, an example in which four wordlines WLO, WLP, WLQ, and WLR are monitored is described, but the number of wordlines to be monitored for the wordline selection operation may be more than or less than 4.

The distribution information generator 121a may perform the on-chip read operations of the wordlines WLO, WLP, WLQ, and WLR based on the first request RQ1. The on-chip read operation may be performed in the single level cell (SLC) manner for identifying the lowest threshold voltage state.

For example, the distribution information generator 121a may perform first to fourth on-chip read operations based on the first request RQ1. In the first on-chip read operation, the distribution information generator 121a may determine memory cells of the wordline WLO, which have the erase state "E," by using the first read voltage level VR1 and may determine an on-cell count value of the wordline WLO as a first count value CV1. The on-cell count value of the wordline WLO may be referred to as "wordline distribution information of the wordline WLO." The distribution information generator 121a may store the wordline distribution information of the wordline WLO as a portion of the distribution information DI in the E-fuse circuit 121c.

As in the above description, in the second on-chip read operation, the distribution information generator 121a may determine memory cells of the wordline WLP, which have the erase state "E," by using the first read voltage level VR1 and may determine an on-cell count value of the wordline WLP as a second count value CV2. In the third on-chip read operation, the distribution information generator 121a may determine memory cells of the wordline WLQ, which have the erase state "E," by using the first read voltage level VR1 and may determine an on-cell count value of the wordline WLQ as a third count value CV3. In the fourth on-chip read operation, the distribution information generator 121a may determine memory cells of the wordline WLR, which have the erase state "E," by using the first read voltage level VR1 and may determine an on-cell count value of the wordline WLR as a fourth count value CV4. Likewise, the distribution information generator 121a may store the wordline distribution information of the wordlines WLP, WLQ, and WLR as a portion of the distribution information DI in the E-fuse circuit 121c.

The wordline selection circuit 121b may determine the deterioration wordline WLx based on the distribution information DI stored in the E-fuse circuit 121c. For example, the distribution information DI includes the first to fourth count values CV1, CV2, CV3, and CV4 respectively corresponding to the on-cell count values of the wordlines WLO, WLP, WLQ, and WLR. A count value being the smallest from among the first to fourth count values CV1, CV2, CV3, and CV4 may be the fourth count value CV4. The wordline selection circuit 121b may determine the wordline WLR having the fourth count value CV4 as the deterioration wordline WLx. The wordline selection circuit 121b may generate the wordline information WI indicating the wordline WLR being the deterioration wordline WLx. The wordline selection circuit 121b may output the wordline information WI through the I/O circuit 127.

For better understanding of the present disclosure, a method in which a deterioration wordline is determined relatively by using on-cell count values is described. However, the present disclosure is not limited thereto. For example, a deterioration wordline may be determined absolutely by comparing an on-cell count value and the first threshold value or may be determined absolutely by comparing an off-cell count value and the second threshold value. Alternatively, a deterioration wordline may be determined based on the valley search information (e.g., a difference between a voltage level of a valley in the initial state and a voltage level of an optimized valley). A deterioration wordline may be determined relatively or absolutely based on a cell count value between two adjacent read voltages.

FIG. 11 is a diagram describing a method of operating a storage device according to some implementations of the present disclosure. Referring to FIG. 11, the storage device 100 includes the storage controller 110 and the non-volatile memory device 120. The storage controller 110 includes a command manager and the ECC engine 116. The command manager includes the wordline manager 111 and the reclaim manager 112. The non-volatile memory device 120 includes the control logic 121, the memory cell array 124, and the I/O circuit 127. The memory cell array 124 includes the plurality of memory blocks BLK1 to BLKM. Each of the plurality of memory blocks BLK1 to BLKM includes the plurality of wordlines WL1 to WLN.

Below, how the storage device 100 performs the read operation on the deterioration wordline WLx will be described. The read operation of the deterioration wordline WLx may be performed after the wordline selection operation of FIG. 9.

In a first operation ①, the reclaim manager 112 may provide the control logic 121 with the second request RQ2 indicating the read operation of the deterioration wordline WLx. The second request RQ2 may include an address of the deterioration wordline WLx.

In a second operation ②, based on the second request RQ2, the control logic 121 may perform the read operation of the deterioration wordline WLx and may generate the read data DT of the deterioration wordline WLx by using the I/O circuit 127 as a result of the read operation. In this case, the read operation may be a logical page-based read operation. For example, unlike the way to determine memory cells having the erase state "E" by using only the first read voltage level VR1 (i.e., only one read voltage level), in FIG. 10, the control logic 121 may perform the read operation of the deterioration wordline WLx by using a plurality of read voltage levels in units of logical page.

In a third operation ③, the I/O circuit 127 may provide the read data DT of the deterioration wordline WLx to the ECC engine 116. The ECC engine 116 may perform the error correction operation of the read data DT to generate an error count value of the deterioration wordline WLx. The error count value may indicate the number of flipped bits in the read data DT of the deterioration wordline WLx or may indicate that the read data DT of the deterioration wordline WLx has an uncorrectable error.

In a fourth operation ④, the reclaim manager 112 may obtain the error count value of the read data DT from the ECC engine 116. The reclaim manager 112 may determine whether the reclaim condition of the target memory block BLKx is satisfied, based on the error count value. For example, when the error count value of the read data DT exceeds a threshold error count value, the reclaim manager 112 may determine that the reclaim condition of the target memory block BLKx is satisfied. The threshold error count value may provide a criterion of reclaim execution. The threshold error count value may correspond to the error correction capability of the ECC engine 116.

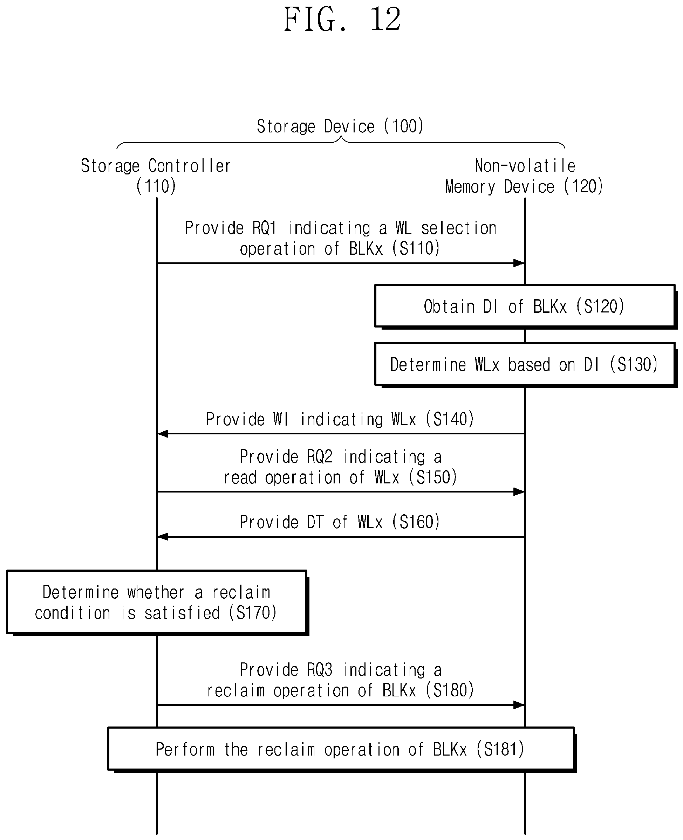

FIG. 12 is a flowchart describing a method of operating a storage device according to some implementations of the present disclosure. Referring to FIG. 12, the storage device 100 includes the storage controller 110 and the non-volatile memory device 120.

In operation S110, the storage controller 110 may provide the non-volatile memory device 120 with the first request RQ1 indicating the wordline selection operation of the target memory block BLKx.

In operation S120, the non-volatile memory device 120 may obtain the distribution information DI of the target memory block BLKx based on the first request RQ1. The distribution information DI may include wordline distribution information corresponding to each of a plurality of wordlines of the target memory block BLKx.

In operation S130, the non-volatile memory device 120 may determine the deterioration wordline WLx based on the distribution information DI. In some implementations, based on the distribution information DI, the non-volatile memory device 120 may determine a plurality of deterioration wordlines or may determine that there is no deterioration wordline in the target memory block BLKx.

In operation S140, the non-volatile memory device 120 may provide the wordline information WI indicating the deterioration wordline WLx to the storage controller 110. The wordline information WI may include at least one of an address of the deterioration wordline WLx and the wordline distribution information of the deterioration wordline WLx. When it is determined in operation S130 that there is no deterioration wordline, the wordline information WI may indicate that there is no deterioration wordline.

In operation S150, the storage controller 110 may provide the non-volatile memory device 120 with the second request RQ2 indicating the read operation of the deterioration wordline WLx based on the wordline information WI.

In operation S160, based on the second request RQ2, the non-volatile memory device 120 may perform the read operation of the deterioration wordline WLx and may provide the read data DT of the deterioration wordline WLx to the storage controller 110.

In operation S170, based on the read data DT of the deterioration wordline WLx, the storage controller 110 may determine whether the reclaim condition of the target memory block BLKx including the deterioration wordline WLx is satisfied. When it is determined that the reclaim condition is not satisfied, the storage controller 110 may again perform operation S110. When it is determined that the reclaim condition is satisfied, the storage controller 110 may perform operation S180.

In operation S180, the storage controller 110 may provide the non-volatile memory device 120 with the third request RQ3 indicating the reclaim operation of the target memory block BLKx.

In operation S181, the storage device 100 may perform the reclaim operation of the target memory block BLKx. In detail, the non-volatile memory device 120 may provide the block data of the target memory block BLKx to the storage controller 110 based on the third request RQ3. The storage controller 110 may store the provided block data in any other memory block of the non-volatile memory device 120. The storage controller 110 may erase the block data of the target memory block BLKx of the non-volatile memory device 120.

As described above, according to some implementations of the present disclosure, as a deterioration wordline is quickly monitored by the on-chip read operation and distribution information of the deterioration wordline is accurately analyzed by a storage controller, a storage device may perform the reliability operation quickly and accurately.

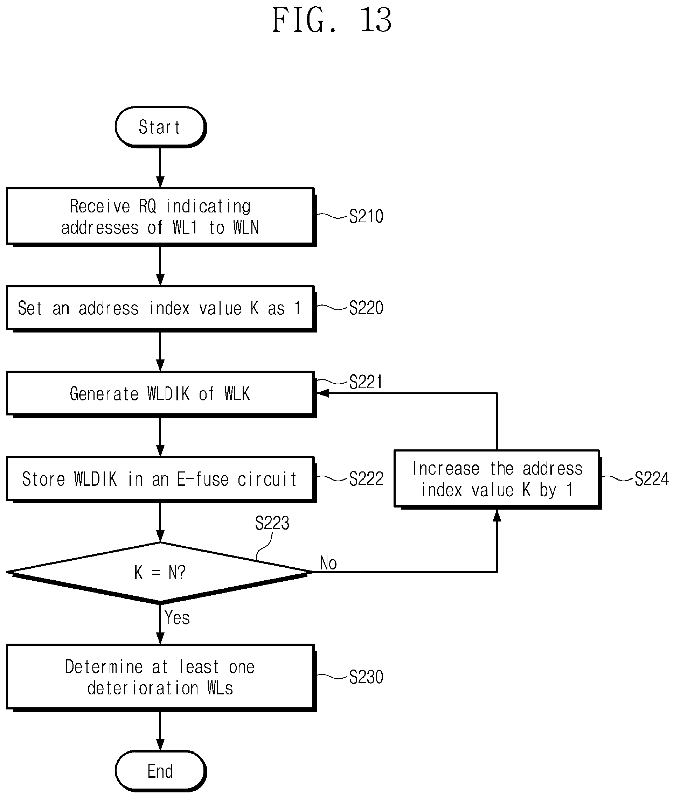

FIG. 13 is a flowchart describing a method of operating a non-volatile memory device according to some implementations of the present disclosure. A method of operating a non-volatile memory device will be described with reference to FIG. 13. Operation S210 may correspond to operation S110 of FIG. 12. Operation S220, operation S221, operation S222, operation S223, and operation S224 may correspond to operation S120 of FIG. 12. Operation S230 may correspond to operation S130 of FIG. 12.

In operation S210, the non-volatile memory device may receive the request RQ indicating addresses of the first to N-th wordlines WL1 to WLN of a target memory block. The first to N-th wordlines WL1 to WLN may be all the wordlines of the target memory block or may be some selected from all the wordlines of the target memory block. In some implementations, "N" may indicate the total number of wordlines targeted for monitoring. The first to N-th wordlines WL1 to WLN mean wordlines to be monitored and are not intended to be limited to physically continuous wordlines in the target memory block. The first to N-th wordlines WL1 to WLN may be physically continuous in the target memory block or may not be physically continuous in the target memory block.

In operation S220, the non-volatile memory device may set an address index value "K" to "1."

In operation S221, the non-volatile memory device may perform the on-chip read operation of the K-th wordline WLK to generate K-th wordline distribution information WLDIK of the K-th wordline WLK. In some implementations, "K" may be the same as the address index value "K" set in operation S220.

In operation S222, the non-volatile memory device may store the K-th wordline distribution information WLDIK in an E-fuse circuit.

In operation S223, the non-volatile memory device may determine whether the address index value "K" is equal to the total number "N" of wordlines targeted for monitoring. When the address index value "K" is different from the total number "N" of wordlines, the monitoring operations of the first to N-th wordlines WL1 to WLN may not be yet completed. In this case, the non-volatile memory device may perform operation S224.

In operation S224, the non-volatile memory device may increase the address index value "K" as much as "1." Afterwards, the non-volatile memory device may further sequentially perform operation S221, operation S222, and operation S223.

When the address index value "K" is equal to the total number "N" of wordlines, all the monitoring operations of the first to N-th wordlines WL1 to WLN may be completed. In this case, the non-volatile memory device may perform operation S230.

In operation S230, the non-volatile memory device may determine at least one deterioration wordlines among the first to N-th wordlines WL1 to WLN, based on the first to N-th wordline distribution information stored in the E-fuse circuit. The non-volatile memory device may generate wordline information indicating the at least one deterioration wordlines thus determined.

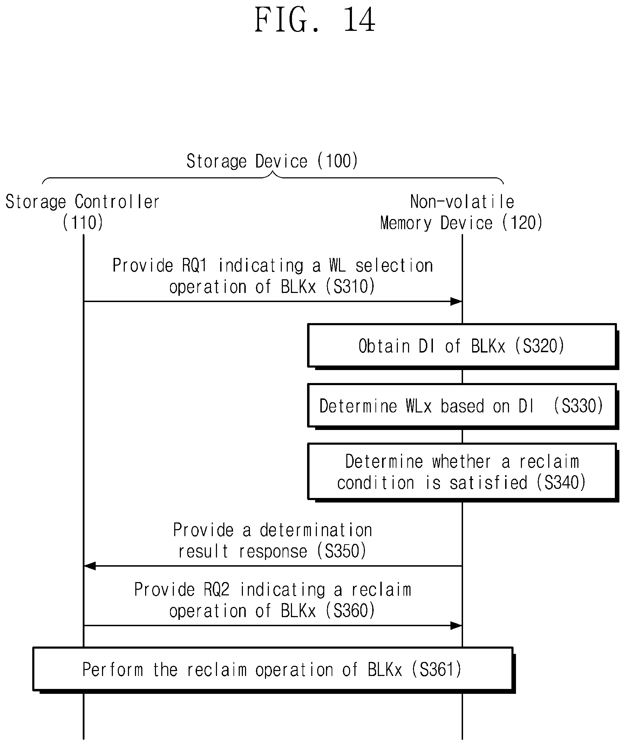

FIG. 14 is a flowchart describing a method of operating a storage device according to some implementations of the present disclosure. Referring to FIG. 14, the storage device 100 includes the storage controller 110 and the non-volatile memory device 120.

In operation S310, the storage controller 110 may provide the non-volatile memory device 120 with the first request RQ1 indicating the wordline selection operation of the target memory block BLKx. In some implementations, the first request RQ1 may further indicate the reclaim decision operation that is based on the deterioration wordline WLx of the target memory block BLKx.

In operation S320, the non-volatile memory device 120 may obtain the distribution information DI of the target memory block BLKx based on the first request RQ1.

In operation S330, the non-volatile memory device 120 may determine the deterioration wordline WLx based on the distribution information DI.

In operation S340, through the on-chip read operation, the non-volatile memory device 120 may determine whether the reclaim condition of the target memory block BLKx including the deterioration wordline WLx is satisfied. For example, based on the wordline distribution information of the deterioration wordline WLx, the non-volatile memory device 120 may determine whether the reclaim condition of the deterioration wordline WLx itself or the reclaim condition of the target memory block BLKx including the deterioration wordline WLx is satisfied. As another example, the non-volatile memory device 120 may further perform the logical page-based read operation with respect to the deterioration wordline WLx and may obtain additional distribution information; in this case, based on the additional distribution information of the deterioration wordline WLx, the non-volatile memory device 120 may determine whether the reclaim condition of the deterioration wordline WLx itself or the reclaim condition of the target memory block BLKx including the deterioration wordline WLx is satisfied.

In operation S350, the non-volatile memory device 120 may provide a determination result response to the storage controller 110. The determination result response may indicate a result in operation S340 where there is determined whether the reclaim condition is satisfied. For example, when it is determined in operation S340 that the reclaim condition is satisfied, the non-volatile memory device 120 may provide the storage controller 110 with the determination result response having a first bit value. As another example, when it is determined in operation S340 that the reclaim condition is not satisfied, the non-volatile memory device 120 may provide the storage controller 110 with the determination result response having a second bit value.

In operation S360, based on the determination result response, the storage controller 110 may provide the non-volatile memory device 120 with the second request RQ2 indicating the reclaim operation of the deterioration wordline WLx itself or the reclaim operation of the target memory block BLKx including the deterioration wordline WLx. For example, when the determination result response indicates the first bit value, the storage controller 110 may provide the second request RQ2 to the non-volatile memory device 120. As another example, when the determination result response indicates the second bit value, the storage controller 110 may again perform operation S310.

In operation S361, based on the second request RQ2, the storage device 100 may perform the reclaim operation of the deterioration wordline WLx itself or the reclaim operation of the target memory block BLKx including the deterioration wordline WLx.

As described above, according to some implementations of the present disclosure, as a deterioration wordline is quickly monitored by the on-chip read operation and distribution information of the deterioration wordline is accurately analyzed by the on-chip read operation, a storage device may perform the reliability operation quickly and accurately.

According to some implementations of the present disclosure, a storage device determining a deterioration wordline and a method of operating the same are provided.

Also, according to some implementations, a storage device that quickly monitors a deterioration wordline through the on-chip read operation and accurately analyzes distribution information of the deterioration wordline through a storage controller and a method of operating the same are provided.

In addition, according to some implementations, a storage device that quickly monitors a deterioration wordline through the on-chip read operation and quickly analyzes distribution information of the deterioration wordline through the on-chip read operation and a method of operating the same are provided.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

While the present disclosure has been described with reference to embodiments thereof, it will be apparent to those of ordinary skill in the art that various changes and modifications may be made thereto without departing from the scope of the present disclosure as set forth in the following claims.

## Claims

1. A method of operating a storage device (100) that includes a storage controller (110) and a non-volatile memory device (120), the method comprising:
providing, by the storage controller (110), the non-volatile memory device (120) with a first request indicating a wordline selection operation of a target memory block (BLKx);
obtaining, by the non-volatile memory device (120) and based on the first request, distribution information (DI) of a plurality of wordlines of the target memory block (BLKx);
determining, by the non-volatile memory device (120) and based on the distribution information (DI), a deterioration wordline (WLx) among the plurality of wordlines; and
providing, by the non-volatile memory device (120), the storage controller (110) with wordline information (WI) indicating the deterioration wordline (WLx),
wherein the distribution information (DI) includes a plurality of pieces of wordline distribution information respectively corresponding to the plurality of wordlines, and
wherein each of the plurality of pieces of wordline distribution information describes a threshold voltage distribution for threshold voltages of memory cells connected to corresponding word line from among the plurality of wordlines.

2. The method of claim 1, further comprising:
providing, by the storage controller (110) and based on the wordline information (WI), the non-volatile memory device (120) with a second request indicating a read operation of the deterioration wordline (WLx);
providing, by the non-volatile memory device (120) and based on the second request, the storage controller (110) with read data (DT) of the deterioration wordline (WLx); and
determining, by the storage controller (110) and based on the read data (DT), whether a reclaim condition of the target memory block (BLKx) is satisfied.

3. The method of claim 2, wherein the determining whether the reclaim condition of the target memory block (BLKx) is satisfied based on the read data (DT) by the storage controller (110) includes:
obtaining, by an error correction code, ECC, engine of the storage controller (110), an error count value of the deterioration wordline (WLx) based on an error correction operation of the read data (DT); and
based on the error count value exceeding a threshold error count value, determining, by the storage controller (110), that the reclaim condition of the target memory block (BLKx) is satisfied.

4. The method of claim 2, further comprising:
providing, by the storage controller (110), the non-volatile memory device (120) with a third request indicating a reclaim operation of the target memory block (BLKx) in response to determining that the reclaim condition of the target memory block (BLKx) is satisfied; and
performing, by the storage device (100), the reclaim operation of the target memory block (BLKx) based on the third request.

5. The method of claim 4, wherein performing the reclaim operation of the target memory block (BLKx) based on the third request by the storage device (100) includes:
providing, by the non-volatile memory device (120), the storage controller (110) with block data of the target memory block (BLKx) based on the third request;
storing, by the storage controller (110), the block data in another memory block of the non-volatile memory device (120); and
erasing, by the storage controller (110), the block data of the target memory block (BLKx) of the non-volatile memory device (120).

6. The method of claim 1, wherein obtaining the distribution information of the plurality of wordlines of the target memory block based on the first request by the non-volatile memory device includes:
performing, by the non-volatile memory device, on-chip read operations of the plurality of wordlines based on the first request; and
storing, by the non-volatile memory device and based on the on-chip read operations, the plurality of pieces of wordline distribution information that respectively correspond to the plurality of wordlines in an E-fuse circuit of the non-volatile memory device.

7. The method of claim 6, wherein each memory cell of the plurality of wordlines is implemented with a triple level cell, TLC, or a quadruple level cell, QLC, and
wherein the on-chip read operations are implemented in a single level cell, SLC, manner and include determining whether the each memory cell of the plurality of wordlines is corresponding to a lowest threshold voltage state or determining whether the each memory cell of the plurality of wordlines is corresponding to a highest threshold voltage state.

8. The method of claim 6, wherein each piece of the plurality of pieces of wordline distribution information (DI) includes at least one of:
an on-cell count value of a corresponding wordline from among the plurality of wordlines;
an off-cell count value of the corresponding wordline;
valley search information of the corresponding wordline; or
a cell count value between two adjacent read voltages of the corresponding wordline.

9. The method of claim 1,
wherein the distribution information (DI) includes a plurality of on-cell count values respectively corresponding to the plurality of wordlines,
wherein each on-cell count value of the plurality of on-cell count values indicates a number of memory cells from among a plurality of memory cells of a corresponding wordline from among the plurality of wordlines, and
wherein the number of memory cells are in at least one of an erase state of a single level cell, SLC, an erase state of a multi-level cell, MLC, an erase state of a triple level cell, TLC, or an erase state of a quadruple level cell, QLC.

10. The method of claim 9, wherein determining the deterioration wordline (WLx) among the plurality of wordlines based on the distribution information (DI) by the non-volatile memory device (120) includes:
determining, by the non-volatile memory device (120) and from among the plurality of wordlines, a wordline as the deterioration wordline (WLx), wherein the deterioration wordline corresponds to a smallest on-cell count value among the plurality of on-cell count values.

11. The method of claim 9, wherein determining the deterioration wordline (WLx) among the plurality of wordlines based on the distribution information (DI) by the non-volatile memory device (120) includes:
determining, by the non-volatile memory device (120) and from among the plurality of wordlines, a wordline as the deterioration wordline (WLx), wherein the deterioration wordline corresponds to an on-cell count value smaller than a first threshold value from among the plurality of on-cell count values.

12. The method of claim 1,
wherein the distribution information (DI) includes a plurality of off-cell count values respectively corresponding to the plurality of wordlines, and
wherein each off-cell count value of the plurality of off-cell count values indicates a number of memory cells from among a plurality of memory cells of a corresponding wordline from among the plurality of wordlines, and
wherein the number of memory cells are in at least one of a program state of a single level cell, SLC, a third programming state of a multi-level cell, MLC, a seventh programming state of a triple level cell, TLC, or a fifteenth programming state of a quadruple level cell, QLC.

13. The method of claim 12, wherein determining the deterioration wordline (WLx) among the plurality of wordlines based on the distribution information (DI) by the non-volatile memory device (120) includes:
determining, by the non-volatile memory device (120) and from among the plurality of wordlines, a wordline as the deterioration wordline (WLx), wherein the deterioration wordline corresponds to a smallest off-cell count value among the plurality of off-cell count values.

14. The method of claim 12, wherein determining the deterioration wordline (WLx) among the plurality of wordlines based on the distribution information (DI) by the non-volatile memory device (120) includes:
determining, by the non-volatile memory device (120) and from among the plurality of wordlines, a wordline as the deterioration wordline (WLx), wherein the deterioration wordline corresponds to an off-cell count value smaller than a second threshold value from among the plurality of off-cell count values.

15. The method of claim 1,
wherein the distribution information (DI) includes a plurality of cell count values respectively corresponding to the plurality of wordlines, each cell count value of the plurality of cell count values being between two adjacent read voltages,
wherein each cell count value of the plurality of cell count values indicates a number of memory cells each having a threshold voltage state between two adjacent read voltage levels associated with a single level cell, SLC, a multi-level cell, MLC, a triple level cell, TLC, or a quadruple level cell, QLC,
wherein determining the deterioration wordline (WLx) among the plurality of wordlines based on the distribution information (DI) by the non-volatile memory device (120) includes
determining, by the non-volatile memory device (120) and from among the plurality of wordlines, a wordline as the deterioration wordline (WLx), wherein the deterioration wordline corresponds to a greatest cell count value among cell count values being between the two adjacent read voltages from among the plurality of cell count values,
determining, by the non-volatile memory device (120) and from among the plurality of wordlines, a wordline as the deterioration wordline (WLx), wherein the deterioration wordline corresponds to a smallest cell count value among the cell count values between the two adjacent read voltages,
determining, by the non-volatile memory device (120) and from among the plurality of wordlines, a wordline as the deterioration wordline (WLx), wherein the deterioration wordline (WLx) has a cell count value greater than a third threshold value from among the cell count values between the two adjacent read voltages, or
determining, by the non-volatile memory device (120) and from among the plurality of wordlines, a wordline as the deterioration wordline (WLx), wherein the deterioration wordline (WLx) has a cell count value smaller than a fourth threshold value from among the cell count values between the two adjacent read voltages.

## Patentansprüche

1. Verfahren zum Betreiben einer Speichervorrichtung (100), die einen Speicher-Controller (110) und eine nichtflüchtige Speichervorrichtung (120) umfasst, wobei das Verfahren umfasst:
Bereitstellen einer ersten Anforderung an die nichtflüchtige Speichervorrichtung (120), welche einen Wortleitungsauswahlvorgang eines Zielspeicherblocks (BLKx) anzeigt, durch den Speicher-Controller (110);
Ermitteln von Verteilungsinformationen (DI) von einer Vielzahl von Wortleitungen des Zielspeicherblocks (BLKx), durch die nichtflüchtige Speichervorrichtung (120) sowie basierend auf der ersten Anforderung;
Bestimmen einer degradierten Wortleitung (WLx) unter der Vielzahl von Wortleitungen durch die nichtflüchtige Speichervorrichtung (120) sowie basierend auf den Verteilungsinformationen (DI); und
Bereitstellen von Wortleitungsinformationen (WI) an den Speicher-Controller (110), welche die degradierte Wortleitung (WLx) angeben, durch die nichtflüchtige Speichervorrichtung (120),
wobei die Verteilungsinformationen (DI) eine Vielzahl von einzelnen Wortleitungs-Verteilungsinformationen umfassen, die jeweils der Vielzahl von Wortleitungen entsprechen, und
wobei jede von der Vielzahl von einzelnen Wortleitungs-Verteilungsinformationen eine Schwellenspannungsverteilung für Schwellenspannungen von Speicherzellen beschreibt, die mit einer entsprechenden Wortleitung aus der Vielzahl von Wortleitungen verbunden sind.

2. Verfahren nach Anspruch 1, ferner umfassend:
Bereitstellen einer zweiten Anforderung an die nichtflüchtige Speichervorrichtung (120), welche eine Leseoperation an der degradierten Wortleitung (WLx) anzeigt, durch den Speicher-Controller (110) sowie basierend auf den Wortleitungsinformationen (WI);
Bereitstellen von Lesedaten (DT) der degradierten Wortleitung (WLx) an den Speicher-Controller (110) durch die nichtflüchtige Speichervorrichtung (120) sowie basierend auf der zweiten Anforderung; und
Bestimmen durch den Speicher-Controller (110) sowie basierend auf den Lesedaten (DT), ob eine Reclaim-Bedingung des Zielspeicherblocks (BLKx) erfüllt ist.

3. Verfahren nach Anspruch 2, wobei das Bestimmen durch den Speicher-Controller (110) basierend auf den Lesedaten (DT), ob die Reclaim-Bedingung des Zielspeicherblocks (BLKx) erfüllt ist, umfasst:
Ermitteln eines Fehlerzählwerts der degradierten Wortleitung (WLx) durch eine Error-Correction-Code-, ECC-, Engine des Speicher-Controller (110) basierend auf einem Fehlerkorrekturvorgang der Lesedaten (DT); und
Bestimmen durch den Speicher-Controller (110), dass die Reclaim-Bedingung des Zielspeicherblocks (BLKx) erfüllt ist, basierend darauf, dass der Fehlerzählwert einen Fehlerzählwert-Schwellenwert überschreitet.

4. Verfahren nach Anspruch 2, ferner umfassend:
Bereitstellen einer dritten Anforderung durch den Speicher-Controller (110) an die nichtflüchtige Speichervorrichtung (120), wobei die dritte Anforderung einen Reclaim-Vorgang des Zielspeicherblocks (BLKx) anzeigt, als Reaktion darauf, dass bestimmt wird, dass die Reclaim-Bedingung des Zielspeicherblocks (BLKx) erfüllt ist; und
Durchführen des Reclaim-Vorgangs des Zielspeicherblocks (BLKx) durch die Speichervorrichtung (100) basierend auf der dritten Anforderung.

5. Verfahren nach Anspruch 4, wobei das Durchführen des Reclaim-Vorgangs des Zielspeicherblocks (BLKx) basierend auf der dritten Anforderung durch die Speichervorrichtung (100) umfasst:
Bereitstellen von Blockdaten des Zielspeicherblocks (BLKx) durch die nichtflüchtige Speichervorrichtung (120) an den Speicher-Controller (110) basierend auf der dritten Anforderung;
Speichern der Blockdaten in einem anderen Speicherblock der nichtflüchtigen Speichervorrichtung (120) durch den Speicher-Controller (110); und
Löschen der Blockdaten des Zielspeicherblocks (BLKx) der nichtflüchtigen Speichervorrichtung (120) durch den Speicher-Controller (110).

6. Verfahren nach Anspruch 1, wobei das Ermitteln der Verteilungsinformationen von der Vielzahl von Wortleitungen des Zielspeicherblocks basierend auf der ersten Anforderung durch die nichtflüchtige Speichervorrichtung umfasst:
Durchführen von On-Chip-Leseoperationen von der Vielzahl von Wortleitungen durch die nichtflüchtige Speichervorrichtung basierend auf der ersten Anforderung; und
Speichern der Vielzahl von einzelnen Wortleitungs-Verteilungsinformationen, die jeweils der Vielzahl von Wortleitungen entsprechen, durch die nichtflüchtige Speichervorrichtung sowie basierend auf den On-Chip-Leseoperationen, in einer E-Fuse-Schaltung der nichtflüchtigen Speichervorrichtung.

7. Verfahren nach Anspruch 6, wobei jede Speicherzelle von der Vielzahl von Wortleitungen als eine Triple-Level-Cell, TLC, oder als eine Quadruple-Level-Cell, QLC, implementiert ist, und
wobei die On-Chip-Leseoperationen in der Weise einer Single-Level-Cell, SLC, implementiert werden und ein Bestimmen umfassen, ob die jeweilige Speicherzelle von der Vielzahl von Wortleitungen einem Zustand einer niedrigsten Schwellenspannung entspricht, oder ein Bestimmen umfassen, ob die jeweilige Speicherzelle von der Vielzahl von Wortleitungen einem Zustand einer höchsten Schwellenspannung entspricht.

8. Verfahren nach Anspruch 6, wobei jede einzelne von der Vielzahl von einzelnen Wortleitungs-Verteilungsinformationen (DI) mindestens eines von Folgendem umfasst:
einen "On"-Zellenzählwert einer entsprechenden Wortleitung aus der Vielzahl von Wortleitungen;
einen "Off"-Zellenzählwert der entsprechenden Wortleitung;
Tal-Suchinformationen der entsprechenden Wortleitung; oder
einen Zellenzählwert zwischen zwei benachbarten Lesespannungen der entsprechenden Wortleitung.

9. Verfahren nach Anspruch 1,
wobei die Verteilungsinformationen (DI) eine Vielzahl von "On"-Zellenzählwerten umfassen, die jeweils der Vielzahl von Wortleitungen entsprechen,
wobei jeder "On"-Zellenzählwert von der Vielzahl von "On"-Zellenzählwerten eine Anzahl von Speicherzellen aus einer Vielzahl von Speicherzellen einer entsprechenden Wortleitung aus der Vielzahl von Wortleitungen anzeigt, und
wobei sich die Anzahl der Speicherzellen in mindestens einem von einem Löschzustand einer Single-Level-Cell, SLC, einem Löschzustand einer Multi-Level-Cell, MLC, einem Löschzustand einer Triple-Level-Cell, TLC oder einem Löschzustand einer Quadruple-Level-Cell, QLC, befindet.

10. Verfahren nach Anspruch 9, wobei das Bestimmen der degradierten Wortleitung (WLx) aus der Vielzahl von Wortleitungen basierend auf den Verteilungsinformationen (DI) durch die nichtflüchtige Speichervorrichtung (120) umfasst:
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung einem kleinsten "On"-Zellenzählwert unter der Vielzahl von "On"-Zellenzählwerten entspricht.

11. Verfahren nach Anspruch 9, wobei das Bestimmen der degradierten Wortleitung (WLx) aus der Vielzahl von Wortleitungen basierend auf den Verteilungsinformationen (DI) durch die nichtflüchtige Speichervorrichtung (120) umfasst:
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung einem "On"-Zellenzählwert unter der Vielzahl von "On"-Zellenzählwerten entspricht, der kleiner ist als ein erster Schwellenwert.

12. Verfahren nach Anspruch 1,
wobei die Verteilungsinformationen (DI) eine Vielzahl von "Off"-Zellenzählwerten umfassen, die jeweils der Vielzahl von Wortleitungen entsprechen, und
wobei jeder "Off"-Zellenzählwert von der Vielzahl von "Off"-Zellenzählwerten eine Anzahl von Speicherzellen aus einer Vielzahl von Speicherzellen einer entsprechenden Wortleitung aus der Vielzahl der Wortleitungen anzeigt, und
wobei sich die Anzahl der Speicherzellen in mindestens einem von einem Programmierzustand von einer Single-Level-Cell, SLC, einem dritten Programmierzustand einer Multi-Level-Cell, MLC, einem siebten Programmierzustand einer Triple-Level-Cell, TLC oder einem fünfzehnten Programmierzustand einer Quadruple-Level-Cell, QLC, befindet.

13. Verfahren nach Anspruch 12, wobei das Bestimmen der degradierten Wortleitung (WLx) aus der Vielzahl von Wortleitungen basierend auf den Verteilungsinformationen (DI) durch die nichtflüchtige Speichervorrichtung (120) umfasst:
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung einem kleinsten Off-Zellenzählwert unter der Vielzahl von Off-Zellenzählwerten entspricht.

14. Verfahren nach Anspruch 12, wobei das Bestimmen der degradierten Wortleitung (WLx) aus der Vielzahl von Wortleitungen basierend auf den Verteilungsinformationen (DI) durch die nichtflüchtige Speichervorrichtung (120) umfasst:
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung einem Off-Zellenzählwert entspricht, der kleiner ist als ein zweiter Schwellenwert aus der Vielzahl von Off-Zellenzählwerten.

15. Verfahren nach Anspruch 1,
wobei die Verteilungsinformationen (DI) eine Vielzahl von Zellenzählwerten umfassen, die jeweils der Vielzahl von Wortleitungen entsprechen, wobei jeder Zellenzählwert von der Vielzahl von Zellenzählwerten zwischen zwei benachbarten Lesespannungen liegt,
wobei jeder Zellenzählwert von der Vielzahl von Zellenzählwerten eine Anzahl von Speicherzellen anzeigt, die jeweils einen Schwellenspannungszustand zwischen zwei benachbarten Lesespannungspegeln aufweisen, die einer Single-Level-Cell, SLC, einer Multi-Level-Cell, MLC, einer Triple-Level-Cell, TLC oder einer Quadruple-Level-Cell, QLC, zugeordnet sind,
wobei das Bestimmen der degradierten Wortleitung (WLx) aus der Vielzahl von Wortleitungen basierend auf den Verteilungsinformationen (DI) durch die nichtflüchtige Speichervorrichtung (120) umfasst:
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung einem größten Zellenzählwert unter den zwischen den beiden benachbarten Lesespannungen liegenden Zellenzählwerten aus der Vielzahl von Zellenzählwerten entspricht,
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung einem kleinsten Zellenzählwert unter den Zellenzählwerten zwischen den beiden benachbarten Lesespannungen entspricht,
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung (WLx) einen Zellenzählwert aufweist, der größer ist als ein dritter Schwellenwert unter den Zellenzählwerten zwischen den beiden benachbarten Lesespannungen, oder
Bestimmen einer Wortleitung als die degradierte Wortleitung (WLx) durch die nichtflüchtige Speichervorrichtung (120) sowie aus der Vielzahl von Wortleitungen, wobei die degradierte Wortleitung (WLx) einen Zellenzählwert aufweist, der kleiner ist als ein vierter Schwellenwert unter den Zellenzählwerten zwischen den beiden benachbarten Lesespannungen.

## Revendications

1. Procédé de fonctionnement d'un dispositif de stockage (100) qui comprend un contrôleur de stockage (110) et un dispositif de mémoire non volatile (120), le procédé comprenant les étapes suivantes :
fournir, par le contrôleur de stockage (110), au dispositif de mémoire non volatile (120), une première requête indiquant une opération de sélection de lignes de mot d'un bloc mémoire cible (BLKx) ;
obtenir, par le dispositif de mémoire non volatile (120) et sur la base de la première requête, des informations de distribution (DI) d'une pluralité de lignes de mot du bloc mémoire cible (BLKx) ;
déterminer, par le dispositif de mémoire non volatile (120) et sur la base des informations de distribution (DI), une ligne de mot dégradée (WLx) parmi la pluralité de lignes de mot ; et
fournir, par le dispositif de mémoire non volatile (120), au contrôleur de stockage (110), des informations de ligne de mot (WI) indiquant la ligne de mot dégradée (WLx),
dans lequel les informations de distribution (DI) comprennent une pluralité d'éléments d'informations de distribution de lignes de mot correspondant respectivement à la pluralité de lignes de mot, et
dans lequel chacun des éléments de la pluralité d'éléments d'informations de distribution de lignes de mot décrit une distribution des tensions de seuil des cellules mémoire connectées à la ligne de mot correspondante.

2. Procédé selon la revendication 1, comprenant en outre les étapes suivantes :
fournir, par le contrôleur de stockage (110) et sur la base des informations de ligne de mot (WI), au dispositif de mémoire non volatile (120), une deuxième requête indiquant une opération de lecture de la ligne de mot dégradée (WLx) ;
fournir, par le dispositif de mémoire non volatile (120) et sur la base de la deuxième requête, au contrôleur de stockage (110), des données de lecture (DT) de la ligne de mot dégradée (WLx) ; et
déterminer, par le contrôleur de stockage (110) et sur la base des données de lecture (DT), si une condition de récupération du bloc mémoire cible (BLKx) est satisfaite.

3. Procédé selon la revendication 2, dans lequel la détermination, par le contrôleur de stockage (110), du fait de savoir si la condition de récupération du bloc mémoire cible (BLKx) est satisfaite sur la base des données de lecture (DT) comprend les étapes suivantes :
obtenir, par un moteur de code de correction d'erreurs, ECC, du contrôleur de stockage (110), une valeur de comptage d'erreurs de la ligne de mot dégradée (WLx) sur la base d'une opération de correction d'erreurs des données de lecture (DT) ; et
sur la base du dépassement, par la valeur de comptage d'erreurs, d'une valeur de comptage d'erreurs seuil, déterminer, par le contrôleur de stockage (110), que la condition de récupération du bloc mémoire cible (BLKx) est satisfaite.

4. Procédé selon la revendication 2, comprenant en outre les étapes suivantes :
fournir, par le contrôleur de stockage (110), au dispositif de mémoire non volatile (120), une troisième requête indiquant une opération de récupération du bloc mémoire cible (BLKx) en réponse à la détermination selon laquelle la condition de récupération du bloc mémoire cible (BLKx) est satisfaite ; et
effectuer, par le dispositif de stockage (100), l'opération de récupération du bloc mémoire cible (BLKx) sur la base de la troisième requête.

5. Procédé selon la revendication 4, dans lequel l'exécution, par le dispositif de stockage (100), de l'opération de récupération du bloc mémoire cible (BLKx) sur la base de la troisième requête comprend les étapes suivantes :
fournir, par le dispositif de mémoire non volatile (120), au contrôleur de stockage (110), des données de bloc du bloc mémoire cible (BLKx) sur la base de la troisième requête ;
stocker, par le contrôleur de stockage (110), les données de bloc dans un autre bloc mémoire du dispositif de mémoire non volatile (120) ; et
effacer, par le contrôleur de stockage (110), les données de bloc du bloc mémoire cible (BLKx) du dispositif de mémoire non volatile (120).

6. Procédé selon la revendication 1, dans lequel l'obtention, par le dispositif de mémoire non volatile, des informations de distribution de la pluralité de lignes de mot du bloc mémoire cible sur la base de la première requête comprend les étapes suivantes :
effectuer, par le dispositif de mémoire non volatile, des opérations de lecture sur puce de la pluralité de lignes de mot sur la base de la première requête ; et
stocker, par le dispositif de mémoire non volatile et sur la base des opérations de lecture sur puce, la pluralité d'éléments d'informations de distribution de lignes de mot qui correspondent respectivement à la pluralité de lignes de mot dans un circuit à fusibles électroniques du dispositif de mémoire non volatile.

7. Procédé selon la revendication 6, dans lequel chaque cellule mémoire de la pluralité de lignes de mot est réalisée sous la forme d'une cellule à trois niveaux, TLC, ou d'une cellule à quatre niveaux, QLC, et
dans lequel les opérations de lecture sur puce sont mises en œuvre selon un mode de cellule à un seul niveau, SLC, et comprennent la détermination du fait de savoir si chacune des cellules mémoire de la pluralité de lignes de mot correspond à un état de tension de seuil le plus bas ou la détermination du fait de savoir si chacune des cellules mémoire de la pluralité de lignes de mot correspond à un état de tension de seuil le plus haut.

8. Procédé selon la revendication 6, dans lequel chaque élément de la pluralité d'éléments d'informations de distribution de lignes de mot (DI) comprend au moins l'une des informations suivantes :
une valeur de comptage de cellules à l'état passant d'une ligne de mot correspondante parmi la pluralité de lignes de mot ;
une valeur de comptage de cellules à l'état bloqué de la ligne de mot correspondante ;
des informations de recherche de vallée de la ligne de mot correspondante ; ou
une valeur de comptage de cellules entre deux tensions de lecture adjacentes de la ligne de mot correspondante.

9. Procédé selon la revendication 1,
dans lequel les informations de distribution (DI) comprennent une pluralité de valeurs de comptage de cellules à l'état passant correspondant respectivement à la pluralité de lignes de mot,
dans lequel chaque valeur de comptage de cellules à l'état passant de la pluralité de valeurs de comptage de cellules à l'état passant indique un nombre de cellules mémoire parmi une pluralité de cellules mémoire d'une ligne de mot correspondante parmi la pluralité de lignes de mot, et
dans lequel le nombre de cellules mémoire se trouve dans au moins un état parmi un état d'effacement d'une cellule à un seul niveau, SLC, un état d'effacement d'une cellule à plusieurs niveaux, MLC, un état d'effacement d'une cellule à trois niveaux, TLC, ou un état d'effacement d'une cellule à quatre niveaux, QLC.

10. Procédé selon la revendication 9, dans lequel la détermination, par le dispositif de mémoire non volatile (120), de la ligne de mot dégradée (WLx) parmi la pluralité de lignes de mot sur la base des informations de distribution (DI) comprend l'étape suivante:
déterminer, par le dispositif de mémoire non volatile (120) et parmi la pluralité de lignes de mot, une ligne de mot comme étant la ligne de mot dégradée (WLx), la ligne de mot dégradée correspondant à la plus petite valeur de comptage de cellules à l'état passant parmi la pluralité de valeurs de comptage de cellules à l'état passant.

11. Procédé selon la revendication 9, dans lequel la détermination, par le dispositif de mémoire non volatile (120), de la ligne de mot dégradée (WLx) parmi la pluralité de lignes de mot sur la base des informations de distribution (DI) comprend l'étape suivante :
déterminer, par le dispositif de mémoire non volatile (120) et parmi la pluralité de lignes de mot, une ligne de mot comme étant la ligne de mot dégradée (WLx), la ligne de mot dégradée correspondant, parmi la pluralité de valeurs de comptage de cellules à l'état passant, à une valeur de comptage de cellules à l'état passant inférieure à une première valeur seuil.

12. Procédé selon la revendication 1,
dans lequel les informations de distribution (DI) comprennent une pluralité de valeurs de comptage de cellules à l'état bloqué correspondant respectivement à la pluralité de lignes de mot, et
dans lequel chaque valeur de comptage de cellules à l'état bloqué de la pluralité de valeurs de comptage de cellules à l'état bloqué indique un nombre de cellules mémoire parmi une pluralité de cellules mémoire d'une ligne de mot correspondante parmi la pluralité de lignes de mot, et
dans lequel le nombre de cellules mémoire se trouve dans au moins un état parmi un état de programmation d'une cellule à un seul niveau, SLC, un troisième état de programmation d'une cellule à plusieurs niveaux, MLC, un septième état de programmation d'une cellule à trois niveaux, TLC, ou un quinzième état de programmation d'une cellule à quatre niveaux, QLC.

13. Procédé selon la revendication 12, dans lequel la détermination, par le dispositif de mémoire non volatile (120), de la ligne de mot dégradée (WLx) parmi la pluralité de lignes de mot sur la base des informations de distribution (DI) comprend l'étape suivante :
déterminer, par le dispositif de mémoire non volatile (120) et parmi la pluralité de lignes de mot, une ligne de mot comme étant la ligne de mot dégradée (WLx), la ligne de mot dégradée correspondant à la plus petite valeur de comptage de cellules à l'état bloqué parmi la pluralité de valeurs de comptage de cellules à l'état bloqué.

14. Procédé selon la revendication 12, dans lequel la détermination, par le dispositif de mémoire non volatile (120), de la ligne de mot dégradée (WLx) parmi la pluralité de lignes de mot sur la base des informations de distribution (DI) comprend l'étape suivante :
déterminer, par le dispositif de mémoire non volatile (120) et parmi la pluralité de lignes de mot, une ligne de mot comme étant la ligne de mot dégradée (WLx), la ligne de mot dégradée correspondant, parmi la pluralité de valeurs de comptage de cellules à l'état bloqué, à une valeur de comptage de cellules à l'état bloqué inférieure à une deuxième valeur seuil.

15. Procédé selon la revendication 1,
dans lequel les informations de distribution (DI) comprennent une pluralité de valeurs de comptage de cellules correspondant respectivement à la pluralité de lignes de mot, chaque valeur de comptage de cellules de la pluralité de valeurs de comptage de cellules étant comprise entre deux tensions de lecture adjacentes,
dans lequel chaque valeur de comptage de cellules de la pluralité de valeurs de comptage de cellules indique un nombre de cellules mémoire ayant chacune un état de tension de seuil compris entre deux niveaux de tension de lecture adjacents associés à une cellule à un seul niveau, SLC, une cellule à plusieurs niveaux, MLC, une cellule à trois niveaux, TLC, ou une cellule à quatre niveaux, QLC,
dans lequel la détermination, par le dispositif de mémoire non volatile (120), de la ligne de mot dégradée (WLx) parmi la pluralité de lignes de mot sur la base des informations de distribution (DI) comprend les étapes consistant à :
déterminer, par le dispositif de mémoire non volatile (120) et parmi la pluralité de lignes de mot, une ligne de mot comme étant la ligne de mot dégradée (WLx), la ligne de mot dégradée correspondant à la plus grande valeur de comptage de cellules parmi les valeurs de comptage de cellules comprises entre les deux tensions de lecture adjacentes parmi la pluralité de valeurs de comptage de cellules,
déterminer, par le dispositif de mémoire non volatile (120) et parmi la pluralité de lignes de mot, une ligne de mot comme étant la ligne de mot dégradée (WLx), la ligne de mot dégradée correspondant à la plus petite valeur de comptage de cellules parmi les valeurs de comptage de cellules comprises entre les deux tensions de lecture adjacentes,
déterminer, par le dispositif de mémoire non volatile (120) et parmi la pluralité de lignes de mot, une ligne de mot comme étant la ligne de mot dégradée (WLx), la ligne de mot dégradée (WLx) ayant, parmi les valeurs de comptage de cellules comprises entre les deux tensions de lecture adjacentes, une valeur de comptage de cellules supérieure à une troisième valeur seuil, ou
déterminer, par le dispositif de mémoire non volatile (120) et parmi la pluralité de lignes de mot, une ligne de mot comme étant la ligne de mot dégradée (WLx), la ligne de mot dégradée (WLx) ayant, parmi les valeurs de comptage de cellules comprises entre les deux tensions de lecture adjacentes, une valeur de comptage de cellules inférieure à une quatrième valeur seuil.
